# EUROPEAN PATENT SPECIFICATION

(11) **EP 1 731 325 B1**
(45) Date of publication and mention of the grant of the patent: **24.02.2010**
(21) Application number: 05727408.6
(22) Date of filing: 28.03.2005
(51) Int. Cl.: B41N 1/22, B32B 5/00, B32B 7/02, G03F 7/00, G03F 7/004, G03F 7/11, B41N 10/04

(54) **HOLLOW CYLINDRICAL PRINTING ELEMENT**
HOHLZYINDRISCHES DRUCKELEMENT
MATÉRIAU DE BASE D'IMPRESSION CYLINDRIQUE CREUX

(30) Priority: 30.03.2004 JP 2004099099
(43) Date of publication of application: 13.12.2006
(73) Proprietor: Asahi Kasei Chemicals Corporation, Tokyo 100-8440 (JP)
(72) Inventor: YAMADA, Hiroshi, 4110031 (JP); YOKOTA, Masahisa, 1920914 (JP)
(74) Representative: Bradley, Josephine Mary
(86) International application number: PCT/JP2005/005751
(87) International publication number: WO 2005/095115

(56) References cited:
- EP-A- 1 195 264
- EP-A- 1 431 842
- WO-A-97/00169
- WO-A1-03/022594
- GB-A- 1 250 912
- GB-A- 2 089 288
- JP-A- 05 505 352
- JP-A- 54 027 801
- JP-A- 2002 240 456
- JP-A- 2003 025 749
- JP-B1- 51 034 322
- JP-U- 62 078 466
- US-A- 3 276 947
- US-A- 5 716 714
- US-B1- 6 190 771

## Description

### TECHNICAL FIELD

The present invention relates to a cylindrical printing original plate, and production method thereof, suitable for the production of a flexographic printing plate from laser engraving or a relief image used in gravure printing; the formation of an anilox roll or a pattern used in surface treatments such as embossing and the like; the formation of printing relief images such as tiles or the like; pattern printing of conductors, semiconductors and insulators used in electronic circuit formation; an antireflection film for optical parts; the pattern printing of a functional material such as color filters, (near) infrared cut filters and the like; as well as for the coating and pattern formation of oriented films, underlayers, light-emitting layers, electron transporting layers and sealant layers in the production of display elements such as liquid crystal displays, organic electroluminescent displays and the like.

### BACKGROUND ART

In the printing field it is common to use cylindrical base materials in a printing machine. For example, in the flexographic printing field, an anilox roll is used for transferring ink onto the plate and the plate drum adhered to the plate, and even in the gravure printing or offset print fields a blanket roll or similar device is used.
Recently, in particular, in the flexographic printing field, rather than employing a method which adheres a sheet-like plate while correctly positioning onto the plate drum, methods are now being employed which adhere the plate to a rigid or a flexible cylindrical support and then insert the adhered plate into the plate drum, or which form a cylindrical printing original plate formed with a patternable resin plate on a cylindrical support, then form a pattern on the surface and insert into the plate drum. When attaching the sheet-like printing plate on which a pattern has been formed on the plate drum, a considerable amount of time is required for accurate positioning, and the operation has to be carefully carried out so that air bubbles do not enter the cushion tape adhered between the plate drum and the sheet-like printing plate in order to ensure thickness accuracy. This operation also suffers from the problem that a substantial amount of time is required.

Regarding a hollow-shaped cylindrical core material which acts as the core of a cylindrical printing element, as is described in Non-Patent Document 1 (Encyclopedia of Plastic Forming, Processing and Recycling, Industrial Research Center of Japan, Encyclopedia Publishing Center) as FRP molding, it is already known to form a cylindrical core material by winding a glass fiber cloth saturated with a heat-curable resin around the surface of a cylindrical support and then subject to heat-curing while applying pressure. Such a hollow cylindrical core material can be obtained from several sleeve manufacturers as sleeves (a hollow cylindrical core material) made from glass fiber reinforced plastic. However, this method suffers from the problem that since a heat-curable resin is used, a great deal of time to carry out the curing is required. In addition, during the printing step, a sheet-like printing element is used by attaching it to the glass fiber reinforced plastic sleeve surface. For this reason, the smoothness of the sleeve surface needs to be ensured, so that during the production process of the glass fiber reinforced plastic sleeve, after the heat curing step the sleeve surface is ground to ensure surface accuracy. This surface polishing has the drawbacks of not only requiring a substantial amount of time, but also that the glass fibers used for reinforcing finely scatter. Moreover, the polishing wheel quickly wears down, since glass fibers are being ground.

Patent Document 1 (JP-B-3391794) describes using a polyester film and a thermoplastic adhesive to form a sleeve (hollow cylindrical core material) for supporting a flexible printing plate. However, in order to immobilize the polyester film, a thermoplastic adhesive is used, thus having the large drawback that deformation is caused due to the heat.
Patent Document 2 (JP-A-7-506780) describes a laser-engravable printing element wherein a laser photosensitive resin layer molded into a sheet on a flexible support is stacked over a cylindrical core material in which a non-photosensitive synthetic resin is reinforced with glass fibers. However, in order to stack the sheet-like photosensitive resin layer, it is a prerequisite that the surface accuracy of the cylindrical core material that is used is good.
Patent Document 3 (JP-A-5-505352) describes obtaining an arbitrarily-shaped structure such as a pipe by impregnating a photosensitive resin in a fibrous object, and then photo-curing. However, there is no disclosure regarding using this structure as a base material to be used in printing. Moreover, there is also no disclosure regarding the use of a specific photoinitiator, so that if the fiber-impregnated material of the photosensitive resin disclosed in Patent Document 3 is used in place of a conventionally used synthetic resin made from fiber reinforced plastic, there is the large drawback that the surface of the resultant photo-cured material will be sticky even if irradiation with light is performed in air, which contains oxygen. Methods used to suppress the inhibitory action of oxygen on curing include blocking oxygen by covering the uncured photosensitive resin surface with a film through which beams can pass, or irradiating with light in an inert gas atmosphere or in an aqueous environment. However, such methods require special procedures in terms of the equipment used.

In the past various hollow cylindrical core materials have been proposed and utilized in the printing process. However, no hollow cylindrical core material used for printing has been known which is obtained by photo-curing a photosensitive resin composition. Accordingly, also unknown is a hollow cylindrical printing element wherein a patternable resin layer or a patterned resin layer is stacked on the surface of such a hollow cylindrical core material. Still further unknown is a method for using a fiber reinforced plastic layer without polishing. Non-Patent Document 1: "Encyclopedia of Plastic Forming, Processing and Recycling", Industrial Research Center of Japan (Encyclopedia Publishing Center)
Patent Document 1: JP-B-3391794
Patent Document 2: JP-A-7-506780
Patent Document 3: JP-A-5-505352

EP 1 431 842 discloses a fusing-station roller for use in a fusing station of an electrostatographic machine, said fusing-station roller being elastically deformable, said fusing-station roller comprising: a core member, said core member being rigid and having a cylindrical outer surface; a resilient layer, said resilient layer being formed on said core member; wherein said resilient layer is a fluoropolymer material, said fluoropolymer material made from an uncured formulation by a curing; wherein said uncured formulation includes a fluoroelastomer; wherein said uncured formulation includes microsphere particles, said microsphere particles having flexible walls; wherein said microsphere particles have a predetermined weight percentage in said uncured formulation; and wherein in addition to said microsphere particles, said uncured formulation includes solid filler particles.

EP 1 195 264 discloses a sleeve, to be drawn over a rotary support in order to define a blanket cylinder of an indirect or offset printing machine, this cylinder cooperating with a lithographic plate cylinder from which it receives the data to be printed and with a support onto which said data are transferred, said support moving between the blanket cylinder and a pressure cylinder, the sleeve comprising an inner cylindrical portion to be drawn over the aforesaid rotary support and having its surface covered by a layered structure comprising at least one compressible layer and an incompressible outer layer arranged to cooperate directly with the lithographic plate and with the support to be printed, characterised in that the layered structure is at least partly of polyurethane material.

US 6 190 771 discloses a fusing assembly for fixing toner to a receiver and having a fuser roller and a pressure roller forming a fixing nip, a metering roller, a polymeric release agent applied to the metering roller and a release agent donor roller for receiving polymeric release agent from the metering roller and applying it to the surface of the fusing roller, the release agent donor roller comprising an outer layer including a silicone material selected so that its swelling in 1000 cts poly(dimethylsiloxane) is less than 6% by weight.

US 5 716 714 discloses a fuser member comprising a core having a polymeric coating wherein said wrinkle index of said fuser member is less than 75, said wrinkle index (WI) being calculated by formula: WI = S + 10/T +H/5 where: S is the stiffness of the core in megaPascals (MPa); T is the thickness of said polymeric coating in millimeters (mm); and H is the hardness (Shore A) of the polymeric coating.

GH 2 089 288 discloses a multilayer printing blanket comprising a printing surface layer less than 50 microns thick, e.g. 5 to 15 microns thick, adapted to receive a printing ink, a compressible layer of microporous polymer, preferably elastomeric polymer, at least 0.3 mm thick and preferably of a density of 0.3 to 0.5 gr/cc., contiguous to the said thin layer, and at least one fabric base ply spaced from the printing surface by the said compressible layer, to which the base ply may be adhered by a layer of adhesive,

US 3 276 947 discloses a lithographic printer's blanket for use in an offset printing press, comprising a carcass having a single layer of multi-cord fabric embedded in a vulcanized elastomeric compound having a Shore "A" durometer value in the range of 30-100, said carcass being coated on one surface with a facing layer comprised of a vulcanized elastomeric compound having a Shore "A" durometer value of 40-70.

GB 1 250 912 discloses a printer's blanket having a carcass which includes a layer of a compressed polyurethane foam.

WO 97/00169 discloses a digital printing blanket carcass for supporting a transfer layer having an outer surface which is capable of transferring electrostatic particles. This carcass includes an upper layer of a resilient material which can withstand a temperature of up to about 150°C, such as silicone rubber, hydrogenated nitrile rubber, an acrylic rubber or a fluoroelastomer. The carcass also includes a compressible layer of elastomeric matrix material having a plurality of open or closed cells therein; and a fabric layer, made from a fiber material which can withstand a temperature of up to about 150°C, such as carbon, boron, a metal, fiberglass, a polyimide, or an aromatic polyamide.

JP 2002 240 456 discloses a sleeve for printing comprising a thin film cylindrical core material obtained by sequentially laminating a first sheet and a second sheet of a C-shaped cross section each having a thickness T of 0.1 to 2.0 mm in a circumferentially deviated manner, so as not to mutually superpose respective gaps of the first and second sheets; and an elastic material made of a vulcanized rubber or the like coating the material,

WO 03 022594 discloses a photosensitive resin composition for printing plate precursors capable of laser engraving which comprises: a) 100 parts by weight of a resin which has a number-average molecular weight of 1,000 to 100,000, contains polymerizable unsaturated groups in a number of at least 0.7 per molecule on the average, and is a plastomer at 20°C; b) 5 to 200 parts by weight of an organic compound having a number-average molecular weight lower than 1,000 and containing at least one polymerizable unsaturated group per molecule; and c) 1 to 100 parts by weight of an inorganic porous material.

### DISCLOSURE OF THE INVENTION

### PROBLEMS TO BE SOLVED BY THE INVENTION

It is an object of the present invention to provide simply and quickly a hollow cylindrical printing element whose plate thickness accuracy and dimensional accuracy are good.

### MEANS FOR SOLVING THE PROBLEMS

The present inventors have carried out extensive studies, arriving at the present invention through their discovering that the above-described problems could be resolved by using a hollow cylindrical printing element which is a cylindrical structure comprising a cured photosensitive resin layer (1) having a thickness of not less than 0.05 mm and not more than 50 mm, wherein a patternable resin layer (B) or patterned resin layer (C) having a thickness of not less than 0.1 mm and not more than 100 mm is stacked on a hollow cylindrical core material (A) acting as the core of the hollow cylindrical printing element, characterized in that the cured photosensitive resin layer (1) comprises a fiber-like, cloth-like, or film-like reinforcement material and has a shore D hardness of not less than 30 degrees and not more than 100 degrees.

That is, the technical concept behind the present invention is that in the above-described hollow cylindrical printing original plate optionally comprising a circumference adjustment layer (F), a cushion layer (E) or a rigid body layer (G), at least the hollow cylindrical core material (A) is formed by photo-curing a photosensitive resin composition. Using a photosensitive resin composition allows a structure comprising a hollow cylindrical core material (A) to be formed within a very short period of time. In addition, since printing can be conducted just by mounting on a printing machine a hollow cylindrical printing plate formed with an uneven pattern on the surface of the hollow cylindrical printing element, the steps of positioning the printing plate on the print drum and immobilizing the printing plate, which are conventionally carried out, can be omitted, whereby it is possible to dramatically simplify the process.

The present invention is as follows.
1. A cylindrical printing element comprising a hollow cylindrical core material (A) which comprises a cured photosensitive resin layer (1) having a thickness of not less than 0.05 mm and not more than 50 mm, said cured photosensitive resin layer (1) having a fiber-like, cloth-like, or film-like reinforcement material.
   said cured photosensitive resin layer (1) comprising a photoinitiator or a degradation product of said photoinitiator, wherein said photoinitiator comprises a hydrogen abstracting photoinitiator and a degradable photoinitiator, or comprises a compound containing in the same molecule a moiety which acts as a hydrogen abstracting photoinitiator and a moiety which acts as a degradable photoinitiator, and said cured photosensitive resin layer (1) having a shore D hardness of not less than 30 degrees and not more than 100 degrees; and
   a resin layer (B) or a resin layer (C) having a thickness of not less than 0.1 mm and not more than 100 mm stacked on said hollow cylindrical core material (A), said resin layer (B) capable of forming a pattern on a surface thereof or said resin layer (C) having a pattern formed on the surface thereof.
2. The cylindrical printing element according to the above-described 1, wherein the resin layer (B) is a photosensitive resin composition layer capable of forming a pattern by a photoengraving technique or is a laser-engravable cured photosensitive resin layer (3).
3. The hollow cylindrical printing element according to the above-described 1, further comprising at least one resin layer (D) stacked on an inner surface of the hollow cylindrical core material (A) to provide a cylindrical structure, said resin layer (D) having a thickness of not less than 0.01 mm and not more than 0.5 mm.
4. The hollow cylindrical printing element according to any one of the above-described 1 to 3, further comprising a cushion layer (E) stacked between the hollow cylindrical core material (A) and the resin layer (B) or resin layer (C) to provide a cylindrical structure, said cushion layer (E) having a thickness of not less than 0.05 mm and not more than 50 mm.
5. The hollow cylindrical printing element according to the above-described 4, further comprising a circumference adjustment layer (F) stacked between the hollow cylindrical core material (A) and the cushion layer (E) to provide a cylindrical structure, said circumference adjustment layer (F) having a thickness of not less than 0.1 mm and not more than 100 mm.

6. The hollow cylindrical printing element according to the above-described 4, further comprising a rigid body layer (G) stacked between the resin layer (B) or resin layer (C) and the cushion layer (E) to provide a hollow cylindrical structure, said rigid body layer (G) having a thickness of not less than 0.01 mm and not more than 0.5 mm.
7. The hollow cylindrical printing element according to any one of the above-described 1 to 6, wherein the cured photosensitive resin constituting at least the hollow cylindrical core material (A) among the hollow cylindrical core material (A), circumference adjustment layer (F), cushion layer (E), rigid body layer (G), resin layer (B) and resin layer (C) is formed by photo-curing a photosensitive resin composition which is in a liquid state at 20°C.
8. The hollow cylindrical printing element according to the above-described 2, wherein the resin layer (B) made of a laser-engravable cured photosensitive resin layer (3) comprises a compound having at least one bond selected from the group consisting of a carbonate bond, a urethane bond and an ester bond, and an inorganic porous material.

9. The hollow cylindrical printing element according to the above-described 1, wherein the hollow cylindrical core material (A) comprises uneven portions on a surface, the uneven portions having a difference in elevation of not less than 20 µm and not more than 500 µm.
10. A hollow cylindrical core material for forming a hollow cylindrical printing element comprising a cured photosensitive resin layer (1) having a thickness of not less than 0.05 mm and not more than 50 mm in thickness, said cured photosensitive resin layer (1) comprising a fiber-like, cloth-like or film-like reinforcement material,
   said cured photosensitive resin layer (1) comprising a photoinitiator or a degradation product of said photoinitiator, wherein said photoinitiator comprises a hydrogen abstracting photoinitiator and a degradable photoinitiator, or comprises a compound containing in the same molecule a moiety which acts as a hydrogen abstracting photoinitiator and a moiety which acts as a degradable photoinitiator, and said cured photosensitive resin layer (1) having a shore D hardness of not less than 30 degrees and not more than 100 degrees.
11. A method for producing a hollow cylindrical printing base material comprising the steps of: applying a photosensitive resin composition which comprises a photoinitiator to a cylindrical support; photo-curing by irradiating with beams containing light which is 200nm to 450nm; adjusting the film thickness of the obtained cured photosensitive resin layer; and stacking a patternable resin layer (B) or surface-patterned resin layer (C) on a hollow cylindrical core material (A) formed from the above-described steps, wherein said photoinitiator comprises a hydrogen abstracting photoinitiator and a degradable photoinitiator, or a compound having in the same molecule a moiety which acts as a hydrogen abstracting photoinitiator and a moiety which acts as a degradable photoinitiator.
12. The method according to the above-described 11 further comprising the step of: providing a fiber-like, cloth-like or film-like reinforcement material on a cylindrical support surface before the step of applying said liquid photosensitive resin composition thereto.
13. The method according to the above-described 11 wherein the step of applying a photosensitive resin composition is the step of winding around a cylindrical support surface a sheet-like material obtained by incorporating a liquid photosensitive resin composition or a semi-cured product of a liquid photosensitive resin composition into a fiber-like, cloth-like or film-like reinforcement material.

14. The method according to the above-described 12 or 13, wherein a method for stacking the resin layer (B) comprises a step of applying a photosensitive resin composition, or a step of applying and then photo-curing a photosensitive resin composition, or a step of adhering a photosensitive resin composition layer formed in a sheet shape via an adhesive or a pressure-sensitive adhesive; and wherein a method for stacking the resin layer (C) comprises the step of adhering a patterned sheet-like material via an adhesive or a pressure-sensitive adhesive.
15. The method according to the above-described 12 or 13, further comprising a step of forming at least one resin layer (D) onto the cylindrical support prior to the step of forming the hollow cylindrical core material (A), wherein said step of forming the resin layer (D) comprises a step of winding a resin film around the cylindrical support so that both edge portions of said resin film do not overlap, and such that a seam formed where the two edge portions meet does not exceed 2 mm, or a step of covering with a seamless resin tube formed in a cylindrical shape, or a step of applying a liquid photosensitive resin composition to a cylindrical support and photo-curing it by irradiating it with light.
16. The method according to any one of the above-described 12 to 15, comprising a step of stacking a circumference adjustment layer (F) on a hollow cylindrical core material (A) prior to the step of stacking the resin layer (B) or resin layer (C), wherein said step of stacking a circumference adjustment layer (F) comprises a step of applying a liquid photosensitive resin to the hollow cylindrical core material (A) and photo-curing it by irradiating it with light.

17. The method according to the above-described 16, comprising a step of stacking a cushion layer (E) on the hollow cylindrical core material (A) or circumference adjustment layer (F) prior to the step of stacking the resin layer (B) or resin layer (C), wherein said step of stacking a cushion layer (E) comprises a step of applying a liquid photosensitive resin to the hollow cylindrical core material (A) or circumference adjustment layer (F) and photo-curing it by irradiating it with light, or a step of adhering a cushion tape via an adhesive layer or a pressure-sensitive adhesive layer.
18. The method according to the above-described 17, comprising a step of stacking a rigid body layer (G) on the cushion layer (E) prior to the step of stacking the resin layer (B) or resin layer (C), wherein said step of stacking a rigid body layer (G) comprises a step of adhering a resin film to the cushion layer (E) via an adhesive layer or a pressure-sensitive adhesive layer, or a step of applying a liquid photosensitive resin composition and photo-curing it by irradiating it with light.
19. The method according to any one of the above-described 12 to 18, further comprising, after a step of forming a cured photosensitive resin layer (1), at least one step selected from the group consisting of a step of cutting a surface, a step of grinding a surface, and a step of polishing a surface.
20. The method according to any one of the above-described 12 to 19, wherein in the step of forming the cured photosensitive resin layer (1) the photosensitive resin composition layer is irradiated with light in air.
21. The method according to any one of the above-described 12 to 20, comprising, after formation of the hollow cylindrical printing element, a step of removing said hollow cylindrical printing element from the cylindrical support.

### ADVANTAGES OF THE INVENTION

The hollow cylindrical printing element according to the present invention has good plate thickness accuracy and dimensional accuracy, and, can be formed simply and quickly.

### BRIEF DESCRIPTION OF THE DRAWING

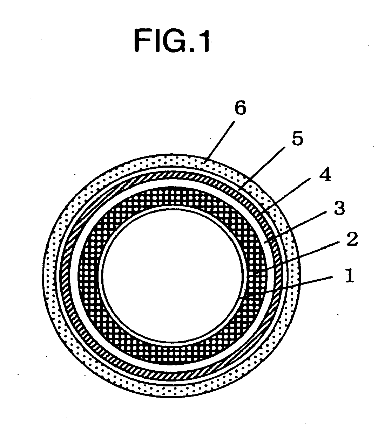

Fig. 1 is a cross-sectional schematic view of a hollow cylindrical printing element according to the present invention.

### BEST MODE FOR CARRYING OUT THE INVENTION

The present invention will now be described in more detail with the description focusing on preferable embodiments thereof. The hollow cylindrical core material (A) according to the present invention is preferably formed from a cured photosensitive resin layer (1) having a thickness of not less than 0.05 mm and not more than 50 mm, preferably not less than 0.1 mm and not more than 20 mm, and more preferably not less than 0.2 mm and not more than 10 mm. In addition, the cured photosensitive resin layer (1) preferably comprises a fiber-like, cloth-like, or film-like reinforcement material.
If the thickness of the cylindrical core material of the present invention is not less than 0.05 mm and not more than 50 mm, morphological stability can be secured, and it is easy to carry around without being especially heavy.
In the present invention, the term "fiber-like" means having a filament-like form, and includes fine fibers which have been bundled up or twisted together. The term "cloth-like" means a woven fabric of fibers or a nonwoven fabric of short fibers which are irregularly joined together. A cloth-like reinforcement material according to the present invention may be either a woven fabric or a nonwoven fabric. Specific examples of organic fibers include, but are not especially limited to, aramid fiber, polyimide fiber, polyester fiber, acrylic fiber and the like. Further, nonwoven fabric can be used which is formed from cellulose nanofibers produced by bacteria. Specific examples of inorganic fibers include glass fiber, carbon fiber and the like. The fiber-like reinforcement material consisting of the above-described organic fibers or inorganic fibers may also be used wound around the surface of a cylindrical support.

The film-like reinforcement material used in the present invention preferably has a thickness of not less than 1 µm and not more than 100 µm. More preferable is in a range of not less than 5 µm and not more than 80 µm, and even more preferable is not less than 10 µm and not more than 50 µm. If the thickness of the film-like reinforcement material is not less than 1 µm and not more than 100 µm, handling of the film-like reinforcement material is easy, and the reinforcement effects of the cured photosensitive resin layer (1) can be sufficiently attained. Although not limited to these examples, the film-like reinforcement material is preferably formed from at least one kind of material selected from the group consisting of polyesters, polyimides, polyamides, polyamideimides, polysulfones, polyetheretherketones, polyphenylene ethers, polyphenylene thioethers and polyolefins. The film-like reinforcement material may also be a laminate of two or more such materials. The linear thermal expansion coefficient of the film-like reinforcement material is preferably not less than -10 ppm/°C and not more than 150 ppm/°C, and more preferably not less than -10 ppm/°C and not more than 100 ppm/°C. If the linear thermal expansion coefficient of the film-like reinforcement material is in the above range, morphological stability of the photosensitive resin cured layer (1) can be sufficiently secured. It is preferable to measure the linear thermal expansion coefficient of the film-like reinforcement material by thermomechanical measurement (TMA) in a temperature range of 20°C to 80°C.

When using a film-like reinforcement material in the present invention, a laminate structure is preferable wherein the film-like reinforcement material and the cured photosensitive resin forming the cured photosensitive resin (1) are alternately stacked over each other. The thickness of the cured photosensitive resin stacked on the film-like reinforcement material is preferably not less than 1 µm and not more than 100 µm. A more preferable range is not less than 5 µm and not more than 80 µm, and an even more preferable range is not less than 10 µm and not more than 50 µm. If the thickness of the cured photosensitive resin is in the above range, the adhesiveness or adhesiveness with the film-like reinforcement material can be sufficiently secured, and the morphological stability of the cured photosensitive resin layer (1) can be ensured. The adhesiveness or adhesiveness between the film-like reinforcement material and the cured photosensitive resin is preferably 50 N/m or.more, more preferably 200 N/m or more, and even more preferably 500 N/m or more. In the present invention "adhesiveness" refers to the property of being able to be peeled away, and is differentiated from adhesiveness, wherein the interface is destroyed when peeled away.
The light transmittance of the film-like reinforcement material used in the present invention in the 350 nm to 370 nm wavelength range is preferably not less than 10% and not more than 100%, more preferably not less than 30% and not more than 100%, and even more preferably not less than 50% and not more than 100%. If the light transmittance is in the above range, the mechanical strength of the cured photosensitive resin formed from light irradiation can be ensured. In particular, if the film-like reinforcement material is wound a plurality of times, it is possible to thoroughly photo-cure the inner side photosensitive resin composition.
The surface of the reinforcement material used in the present invention may also be modified with a compound having a polymerizable unsaturated group. For example, a functional group, such as a hydroxyl group or the like, which is exposed on the reinforcement material surface can be made to chemically react using a silane coupling agent, a titanium coupling agent or the like, having a functional group such as an acrylic group, a methacrylic group, a mercapto group, a vinyl group or the like. For an organic reinforcement material, the above-described silane coupling agent or titanium coupling agent can also be used to cause a reaction by forming an active functional group, such as a hydroxyl group or the like on the surface, from surface treatment which irradiates with plasma, vacuum ultraviolet rays or the like.

The shore D hardness of the cured photosensitive resin layer (1) according to the present invention is not less than 30 degrees and not more than 100 degrees, more preferably not less than 40 degrees and not more than 100 degrees and even more preferably not less than 50 degrees and not more than 100 degrees. If the shore D hardness is not less than 30 degrees and not more than 100 degrees, it is easy to maintain the shape in cylindrical form, and morphological stability can be secured. A photosensitive resin composition (6) contains, as components, a resin (a) having a number average molecular weight of not less than 1,000 and not more than 300,000, and an organic compound (b) having a number average molecular weight of less than 1,000 and which has a polymerizable unsaturated group in the molecule. To obtain a cured photosensitive resin layer
(1) in the above-described hardness range, the composition preferably comprises a compound structure that contains the resin (a) and the organic compound (b) having two or more polymerizable unsaturated groups, three or more polymerizable unsaturated groups in the molecule in an amount of 10% by weight or more, and more preferably 20% by weight or more with respect to the resin (a) and/or the organic compound (b) in total. It is further preferable to contain 10% by weight or more, and more preferably 20% by weight or more, with respect to the total weight of the resin (a) and/or organic compound (b), of a compound having a rigid skeleton moiety consisting of an aromatic hydrocarbon group and/or alicyclic hydrocarbon group or the like in such resin (a) and organic compound (b) molecule. Further, the monomer unit having a rigid moiety preferably comprises 1% or more, preferably 5% or more, and more preferably 10% or more, of the monomer units constituting the resin (a).

When polishing the surface of the hollow cylindrical core material (A) according to the present invention, the elevation difference of the uneven portions existing on the surface preferably has a maximum value of not more than 30 µm, more preferably not more than 20 µm and even more preferably not more than 10 µm. If the elevation difference maximum value is not more than 30 µm, a sheet-like printing original plate, printed plate, blanket or the like can be directly adhered. The surface of the hollow cylindrical core material (A) does not have to be smoothed by polishing. It is acceptable for uneven portions to be present on the surface. In such case, because no polishing step is undergone, the production time of the hollow cylindrical core material (A) can be dramatically shortened, and there is no flying about of the inorganic reinforcement material powder, such as glass fibers or the like. If uneven portions are present on the surface, the elevation difference of the uneven portions is preferably not less than 20 µm and not more than 500 µm. If the elevation difference is in this range, air bubbles can be prevented from being caught up when applying the liquid photosensitive resin to the above-described hollow cylindrical core material (A) and forming the layer to be stacked thereon. The elevation difference of the uneven portions present on the cylindrical core material (A) surface of the present invention is measured using a contact displacement sensor (AT3-010^{™}, manufactured by Keyence Corporation), by fixing the contact displacement sensor and then rotating the cylindrical core material (A) which is fixed to a cylindrical support, such as an air cylinder, therearound one time, so that the circumference at one location is measured. The rotational speed of the cylindrical core material (A) is preferably set so that the responses from the contact sensor can be tracked (1 rotation or less per second is preferable). Further, three measuring locations are used, one being a center portion location of the cylindrical core material (A), and two locations being 1 cm from the ends. An arbitrarily selected point on the cylindrical support surface is set as a reference point. The three measuring positions measure the elevation difference at the arbitrarily selected point on the cylindrical support surface as a reference point, wherein the maximum value of the elevation difference of the three measuring position with respect to the reference point is defined as the maximum value of the elevation difference of the uneven portions in the present invention. In this measuring method, because one point of the cylindrical support serves as a reference point, the elevation difference over the entire surface of the cylindrical support is preferably 10 µm or less, and more preferably 5 µm or less, with respect to the reference location. Therefore, the production accuracy of the air cylinder and the equipment for fixing and rotating the air cylinder is preferably less than 10 µm, and more preferably less than 5 µm.

The cured photosensitive resin layer (1) constituting the hollow cylindrical core material (A) and a layer (4) constituting the resin layer (D) are both preferably formed by photo-curing in air the photosensitive resin compositions (6) and (7) which are in a liquid state at 20°C. A preferable viscosity at 20°C of the liquid photosensitive resin compositions is not less than 10 Pa·s and not more than 50 kPa·s, more preferably not less than 50 Pa·s and not more than 20 kPa·s and even more preferably not less than 100 Pa·s and not more than 10 kPa·s. Liquid resins are easily applied in a cylindrical shape, and if in the above-described viscosity range, molding can be easily carried out without any liquid dripping due to gravity.

The method for forming the cured photosensitive resin layer (1) which constitutes the hollow cylindrical core material (A) according to the present invention comprises the steps of: applying a photosensitive resin composition (6) to a cylindrical support; photo-curing by irradiating with beams containing light which is not less than 200 nm and not more than 450 nm; and adjusting the film thickness of the obtained cured photosensitive resin layer. The method for applying the photosensitive resin composition (6) to a cylindrical support is not especially limited. Examples of coating methods include commonly used methods, such as spray coating, blade coating, gravure coating, reverse-roller coating, kiss-touch coating, high-pressure air knife coating and the like. Rotating the cylindrical support on its axis when applying the photosensitive resin composition (6) is effective for an even coating. In addition, the light source used for photo-curing of the formed cured photosensitive resin layer (1) preferably generates beams which contain light of not less than 200 nm and not more than 450 nm. Examples include, but are not especially limited to, metal halide lamps, high-pressure mercury lamps, ultrahigh-pressure mercury lamps, carbon arc lamps, chemical lamps, germicidal lamps and the like. Light irradiation can be performed simultaneously with application of the photosensitive resin composition (6), or may be performed after the application. Adjustment of the film thickness of the cured photosensitive resin layer (1) obtained from the light irradiation can be carried out by combining a cutting method using a blade such as the cutting tool of a lathe or the like; a cutting method using a rotating abrasive wheel; and a polishing method using an abrasive cloth. Of course, the process can also be carried out while rotating around the axis of the cylindrical body. In addition, the step of adjusting the cured photosensitive resin layer (1) film thickness does not have to be performed.

Prior to applying the photosensitive resin composition (6), a step of winding a fiber-like, cloth-like or film-like material around the cylindrical support surface can also be included. While the method for winding a fiber-like, cloth-like or film-like material is not especially limited, a method which winds a material molded into a ribbon in a spiral shape is preferred, as the effect of maintaining the strength of the hollow cylindrical core material (A) is large. A photosensitive resin composition (6) or a material comprising a partially cured substance of the photosensitive resin composition (6) can also be used on the surface or in the interior of the fiber-like or cloth-like material, or on the surface of the film-like material, which is wound around the cylindrical support. Since a partially cured substance has an especially sticky surface, it is effective in allowing the step of winding around the cylindrical support to be easily carried out. The term "partially cured substance of the photosensitive resin composition (6)" refers to the photo-cured state of a cured photosensitive resin prior to the stage at which the photosensitive resin composition (b) is completely cured, whereby hardness or other such physical properties stops changing. Such a substance can be easily obtained by setting the amount of irradiation light at a lower level. A rough measure of the amount of light which can form a partially cured substance would be 80% or less of the minimum amount of light at which hardness or other such physical properties stops changing. More preferred is 50% or less, and still more preferred is 30% or less. In the case of winding around the cylindrical support a fiber-like, cloth-like or film-like material to which the photosensitive resin composition (6) has been applied the method for applying the photosensitive resin composition (6) is not especially limited, and a commonly known method may be employed. In order to carry out application in a uniform manner, preferable are methods using a doctor blade, roll coating and spray coating. Further, the object may also be such that the photosensitive resin composition (6) has been saturated into the interior (in the space between fibers) of a fiber-like or cloth-like material, or filled by impregnating therein. Photo-curing may also be performed while winding around the cylindrical support the fiber-like or cloth-like material comprising a partially cured substance of the photosensitive resin composition (6). This method is effective in securing light transmittance in the case of stacking a fiber-like or cloth-like material.

The photosensitive resin hardened layer (1) constituting the hollow cylindrical core material (A) according to the present invention preferably comprises a compound which has a rigid skeleton moiety consisting of an aromatic hydrocarbon group and/or alicyclic hydrocarbon group or the like. Here, the term "aromatic hydrocarbon group" refers to a functional group having an atomic group wherein one hydrogen atom has been removed from the skeleton of an aromatic compound, such as a phenyl group, tolyl group, xylyl group, biphenyl group, naphthyl group, anthryl group, phenanthryl group, pyrenyl group and the like. The term "alicyclic hydrocarbon group" refers to, among carbocyclic compounds having a structure in which a carbon atom is bonded to a ring, those functional groups whose remaining atomic group has one hydrogen atom removed from a compound which is not classified as an aromatic compound. Examples include a cyclohexyl group, bicyclooctyl group, cyclopentadienyl group, cyclooctyl group and the like. By having such skeleton moieties, the shore D hardness of the photosensitive resin hardened layer (1) can be increased, which is effective in maintaining rigidity and in securing dimensional stability.
The photosensitive resin composition (6) for forming the photosensitive resin hardened layer (1) according to the present invention preferably comprises a resin (a) whose number average molecular weight is not less than 1,000 and not more than 300,000, an organic compound (b) whose number average molecular weight is less than 1,000 and which has a polymerizable unsaturated group in the molecule, and a photoinitiator. It is especially preferable for the photoinitiator to comprise a hydrogen abstracting photoinitiator and a degradable photoinitiator, or to be a compound having in the same molecule a moiety which acts as a hydrogen abstracting photoinitiator and a moiety which acts as a degradable photoinitiator, because the photo-curing photosensitive resin composition can be photo-cured in air by a radical polymerization reaction.

Examples of the resin (a) are not particularly limited, and commonly known polymer compounds can be used. Especially preferable are compounds which have in the molecule a rigid molecular structure such as an aromatic hydrocarbon compound and/or alicyclic hydrocarbon compound or the like. Specific preferred examples of polymer compounds include rubber polymer compounds having a high degree of hardness and having rubber elasticity, such as a synthetic rubber, thermoplastic elastomers or the like; resins which are solid at 20°C, such as thermoplastic resins having a high elastic modulus; or resins which are a liquid at 20°C and have a polymerizable unsaturated group in the molecule, such as unsaturated polyurethane resins, unsaturated polyester resins, and liquid polybutadienes. Examples of rubber polymer compounds include natural rubber, stryrene-butadiene rubber, acrylonitrile-butadiene rubber, polybutadiene rubber, polyisoprene rubber, ethylene-propylene rubber and polymers of a monovinyl-substituted aromatic hydrocarbon monomer and a conjugated diene monomer. Examples of monovinyl-substituted aromatic hydrocarbon monomers include styrene, α-methylstyrene, p-methylstyrene, and p-methoxystyrene; and examples of conjugated diene monomers include butadiene and isoprene and the like. Representative examples of thermoplastic elastomers include styrene-butadiene block copolymers and styrene-isoprene block copolymers. Examples of thermoplastic resins having a high elastic modulus include polycarbonate, polysulfone, polyethersulfone, polyamide, polyamic acid, polyester, polyphenyleneether and the like. For a resin which is solid at 20°C, especially preferable are those which can dissolve in a solvent. A preferable range for the number average molecular weight of the resin (a) is not less than 1,000 and not more than 300,000, and more preferably is not less than 5,000 and not more than 100,000, and even more preferably is not less than 7,000 and not more than 50,000. "Number average molecular weight" according to the present invention is determined by GPC (gel permeation chromatography) in which polystyrene having a known molecular weight is used as a standard to calculate the value.

The above term "polymerizable unsaturated group" is preferably a functional group which participates in a radical, addition, or ring-opening polymerization reaction. Examples of polymerizable unsaturated groups which participate in a radical polymerization reaction include a vinyl group, an acetylene group, a methacryl group and an acryl group. Examples of polymerizable unsaturated groups which participate in an addition polymerization reaction include a cinnamoyl group, a thiol group and an azido group. Further, examples of polymerizable unsaturated groups which participate in a ring-opening polymerization reaction include an epoxy group, an oxetane group, a cyclic ester group, a dioxysilane group, a spiro-o-carbonate group, a spiro-o-ester group, a bicyclo-o-ester group, a cyclosiloxane group and a cyclic iminoether group.

From the viewpoint of photo-curing the photosensitive resin in air, the resin (a) preferably comprises, either at least one kind of organic group in the molecule selected from the group consisting of an aryl group, a linear or branched alkyl group substituted with at least one aryl group, an alkyl group, an alkoxycarbonyl group, a hydroxyl group, and a formyl group; or has a carbonate bond or an ester bond, and comprises a hydrogen atom (α-position hydrogen atom) bonded to a carbon atom to which the organic group or the bond is directly bonded in an amount of 2% or more with respect to total hydrogen atoms in the molecule. While the reason is not clear, by using a compound having a the above-described specific functional group, and whose organic group has a hydrogen atom bonded to a directly bonded carbon atom, a photosensitive resin composition is provided which is capable of photo-curing even in air. Preferable examples of the aryl group include a phenyl group, tolyl group, xylyl group, biphenyl group, naphthyl group, anthryl group, pyrenyl group, phenanthryl group and the like. Further, preferable examples of the linear or branched alkyl group substituted with an aryl group include a methylstyryl group, a styryl group and the like. The α site hydrogen content can be analyzed by nuclear magnetic resonance spectroscopy (¹H-NMR) focused on the hydrogen atoms.
If the photosensitive resin composition (6) contains a solvent component, the resin (a) component is preferably in the range of 10 to 90% by weight based on the nonvolatile component total weight. More preferable is from 20 to 80% by weight, and still more preferable is from 30 to 70% by weight.
The organic compound (b) having a polymerizable unsaturated group which is included in the photosensitive resin composition (6) is a compound which participates in a radical, addition, or ring-opening polymerization reaction. Commonly know compounds may be used therefor, and no particular limitations exist.

Examples of compounds which participate in a radical reaction include olefins, such as ethylene, propylene, styrene and divinylbenzene; acetylene type compounds; (meth)acrylic acid and derivatives thereof; haloolefins; unsaturated nitriles, such as acrylonitrile; (meth)acrylamide and derivatives thereof; unsaturated dicarboxylic acids (such as maleic anhydride, maleic acid and fumaric acid) and derivatives thereof; vinyl acetate; N-vinylpyrrolidone; and N-vinylcarbazole. From the viewpoint of availability of the various products and cost etc., (meth)acrylic acid and derivatives thereof are preferred. Examples of the derivatives include compounds having an aliphatic group, such as a cycloalkyl group, a bicycloalkyl group, a cycloalkynyl group or a bicycloalkenyl group; compounds having an aromatic group, such as a benzyl group, a phenyl group, a phenoxy group or a naphthalene skeleton, an anthracene skeleton, a biphenyl skeleton, a phenanthrene skeleton, a fluorene skeleton and the like; compounds having a group, such as an alkyl group, a halogenated alkyl group, an alkoxyalkyl group, a hydroxyalkyl group, an aminoalkyl group, or a glycidyl group; and esters with a polyol, such as an alkylene glycol, a polyoxyalkylene glycol, a polyalkylene glycol or a trimethylol propane; and compounds having a polysiloxane structure such as polydimethylsiloxane, polydiethylsiloxane and the like. Such examples may also include a heterocyclic aromatic compound containing nitrogen, sulfur or similar element.

Examples of polymerizable unsaturated groups which participate in an addition polymerization reaction include a cinnamoyl group, a thiol group, and an azido group. Further, examples of polymerizable unsaturated groups which participate in a ring-opening polymerization reaction include an epoxy group, an oxetane group, a cyclic ester group, a dioxysilane group, a spiro-o-carbonate group, a spiro-o-ester group, a bicyclo-o-ester group, a cyclosiloxane group and a cyclic iminoether group. Examples of compounds having a particularly useful epoxy group include compounds which are obtained by reacting epichlorohydrin with any of various polyols (such as diols and triols); and epoxy compounds obtained by reacting a peracid with an ethylenic bond in the molecule. Specific examples of such compounds include epoxy compounds such as ethylene glycol diglycidyl ether, diethylene glycol diglycidyl ether, triethylene glycol diglycidyl ether, tetraethylene glycol diglycidyl ether, polyethylene glycol diglycidyl ether, propylene glycol diglycidyl ether, tripropylene glycol diglycidyl ether, polypropylene glycol diglycidyl ether, neopentyl glycol diglycidyl ether, 1,6-hexanediol diglycidyl ether, glycerin diglycidyl ether, glycerin triglycidyl ether, trimethylol propane triglycidyl ether, bisphenol A diglycidyl ether, hydrogenated bisphenol A diglycidyl ether, diglycidyl ethers of a compound formed by addition-bonding ethylene oxide or propylene oxide to bisphenol A, polytetramethylene glycol diglycidyl ether, poly(propylene glycol adipate)diol diglycidyl ether, poly(ethylene glycol adipate)diol diglycidyl ether, poly(caprolactone)diol diglycidyl ether and the like; and epoxy-modified silicone oils.

To increase the mechanical strength of the cured photosensitive resin layer (1) constituting the hollow cylindrical core material (A), it is preferred that at least one alicyclic hydrocarbon compound or aromatic hydrocarbon compound is incorporated as the resin (a) or organic compound (b). It is preferred that such alicyclic hydrocarbon compound or aromatic hydrocarbon compound is 20% by weight or more, and more preferably 50% by weight or more, of the total amount of resin (a) or organic compound (b). Further, derivatives of the aromatic hydrocarbon compound may also contain nitrogen, sulfur or similar element.
The ratio for the resin (a) and organic compound (b) in the photosensitive resin composition (6) is, per 100 parts by weight of resin (a), preferably in the range of 5 to 200 parts by weight of organic compound (b), and more preferably from 20 to 100 parts by weight.

As the photoinitiator (c) contained in the photosensitive resin composition (6), a photoinitiator comprising a hydrogen abstracting photoinitiator and a degradable photoinitiator is used. For example, known radical polymerization initiators such as aromatic ketones or benzoyl ethers can be used. Examples from among benzophenone, Michler's ketone, benzoin methyl ether, benzoin ethyl ether, benzoin isopropyl ether, α-methylol benzoin methyl ether, α-methoxy benzoin methyl ether, 2,2-dimethoxyphenylaceto-phenone and acylphosphine oxido can be used. Combinations of such compounds can also be used. Especially when carrying out the photo-curing in air, the combination of a hydrogen abstracting photoinitiator such as benzophenone and a degradable photoinitiator such as 2,2-dimethoxyphenylaceto-phenone is particularly preferable. Advantageous effects in photo-curing in air can also be seen by using a compound having in the same molecule a moiety which acts as a hydrogen abstracting photoinitiator and a moiety which acts as a degradable photoinitiator. α-aminoaceto phenones can be given as examples of such a compound. Such examples include compounds represented by the below general formula (1), such as 2-methyl-1-(4-methylthiophenyl)-2-morpholino-propane-1-one, 2-benzyl-2-dimethylamino-1-(4-morpholinophenyl)-butanone: 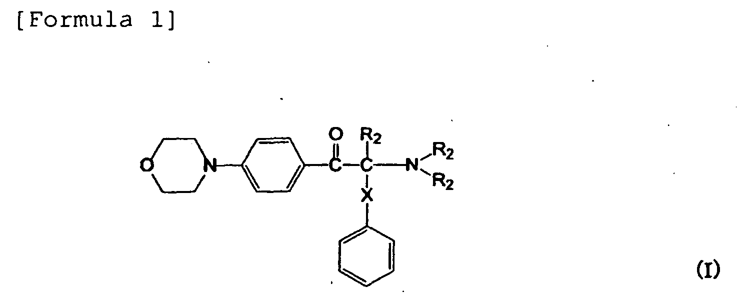 wherein each R₂ independently represents a hydrogen atom or an alkyl group having from 1 to 10 carbons; and X represents an alkylene group having from 1 to 10 carbons.

Further examples include photocationic polymerization initiators which generate an acid by absorbing light, such as an aromatic diazonium salt, an aromatic iodonium salt and an aromatic sulfonium salt; or photoinitiators thereof which generate a base by absorbing light. The photoinitiator is preferably used in an amount of 0.01 to 10% by weight, based on the total weight of resin (a) and organic compound (b).
In the present invention a resin layer (D) can be provided as an optional layer. As shown by reference numeral 1 in Fig. 1, the resin layer (D) is provided on the inner surface of the hollow cylindrical core material (A) (reference numeral 2) consisting of the cured photosensitive resin layer (1). The resin layer (D) has a different composition from the photosensitive resin composition (6) which forms the cured photosensitive resin layer (1), and has a thickness of not less than 0.01 mm and not more than 1 mm, preferably not less than 0.05 mm and not more than 0.5 mm. The resin layer (D) is used for alleviating the uneven portions of the inner surface of the cured photosensitive resin layer (1) which contains a reinforcement material. The resin layer (D) is also effective when using fibers as a reinforcement material. The material which constitutes the resin layer (D) may be a film made from resin or a tube made from resin which is molded into a cylindrical shape. In the case of winding a film made from resin around the cylindrical support, it is preferable to wind such that both edge portions of the resin film do not overlap, and such that the seam formed where the two edge portions meet does not exceed 2 mm. Further, the resin layer (D) may be a cured photosensitive resin layer (4) which has a different composition from the cured photosensitive resin layer (1) which contains the reinforcement material. Particularly preferred is a seamless resin layer (D). If the resin layer (D) thickness is not less than 0.01 mm and not more than 0.5 mm, the uneven portions of the inner surface of the cured photosensitive resin layer (1) which contains a reinforcement material can be sufficiently alleviated.

Further, microparticles can also be incorporated as the reinforcement material in order to reduce friction of the inner surface of the resin layer (D). The average particle size of the incorporated microparticles is preferably not less than 0.01 µm and not more than 100 µm, more preferably not less than 0.05 µm and not more than 20 µm, and still more preferably not less than 0.1 µm and not more than 10 µm. If the average particle size is not less than 0.01 µm and not more than 100 µm, it is effective in reducing friction of the inner surface of the resin layer (D). In addition, the microparticles are preferably spherical in shape. Spherical microparticles whose sphericity is in the range of 0.5 to 1 preferably make up at least 70% of the total number of particles. If the number of spherical microparticles is within this range, it is effective in reducing friction of the inner surface of the resin layer (D). "Sphericity" according to the present invention is defined as the ratio between the radius R1 of the maximum circle which completely encloses the shape projected by a fine particle and the radius R2 of the minimum circle which is completely enclosed by the projected shape (i.e. R1/R2) when observing the microparticles with a scanning electron microscope. The number of spherical microparticles is measured by observing with a scanning electron microscope at a magnification at which at least about 100 particles can be seen. It is preferable to utilize image recognition software in the measurement. "Spherical microparticle" as used in the present invention does not have to be a perfect sphere, and spheres having a smooth surface without any projections or the like on their surface are also included. Examples of the material for the microparticles include hard ceramics such as silicon nitride, boron nitride and silicon carbide and the like; hard metals such as titanium, chromium and the like; and organic materials having a fluorine atom or a silicon atom, such as polytetrafluoroethylene, polydimethylsiloxane and the like.

In the present invention a circumference adjustment layer (F) can be provided as an optional layer. The circumference adjustment layer (F) can be provided on the hollow cylindrical core material (A) according to the circumference of the printing plate to be used. The circumference of the printing plate varies greatly depending on the printed object which is to be produced. Conventionally, to adjust the circumference hard rubber was wound around a cylindrical core material, and was then subjected to the steps of vulcanized crosslinking, surface polishing, and crosslinking stabilization, which required a considerable time to produce the layer. Alternatively, an extremely large quantity of hollow cylindrical core material (A) types were prepared in advance according to circumference, which had to be stored. The present invention resolves this problem.
The circumference adjustment layer (F) combines the function of adjusting the circumference of a printing plate with the function of smoothing the uneven portions of the surface of the hollow cylindrical core material (A). For example, in the case of a typically used glass fiber reinforced plastic cylindrical core material, uneven portions on the surface are very large, so that to produce a rubber-provided cylindrical laminate body which has a hard rubber wound thereon, a separate operation is necessary for improving the smoothness by polishing the surface of the hollow cylindrical core material. This not only requires time, but also has the drawback of substantially increasing production costs. If a circumference adjustment layer (F) is produced using a liquid photosensitive resin in particular, its ability of tracking the uneven portions of the hollow cylindrical core material (A) surface is very good, so that there is no need to grind the surface of the hollow cylindrical core material (A). Of course, a polishing treatment can be performed for finishing of the surface.
The material of the circumference adjustment layer (F) according to the present invention is not especially limited, but is preferably a hardened material of the photosensitive resin composition (9). This hardened material hardness preferably has a shore D hardness of not less than 5 degrees and not more than 100 degrees, more preferably not less than 20 degrees and not more than 100 degrees, and still more preferably not less than 30 degrees and not more than 100 degrees. If the shore D hardness is not less than 5 degrees and not more than 100 degrees, dimensional stability in the thickness direction during printing can be sufficiently ensured.

The photosensitive resin composition (9) which constitutes the circumference adjustment layer (F) may be at 20°C a solid photosensitive resin composition or a liquid photosensitive resin. However, from the viewpoint of being able to freely change the thickness of the circumference adjustment layer (F), a liquid photosensitive resin composition is especially preferable. While a solvent may be included in the liquid photosensitive resin composition, since this requires a step for removing the solvent, a solventless liquid photosensitive resin composition is more preferable. If a liquid photosensitive resin composition is used, a seamless layer can be formed having a uniform thickness. A preferable viscosity at 20°C of the liquid photosensitive resin composition is not less than 10 Pa·s and not more than 10 kPa·s, and more preferably not less than 500 Pa·s and not more than 5 kpa·s. Since film thickness can change due to drips caused by gravity, the above viscosity range is preferable in order to form a thick film. If the film thickness to be molded is very thin, it is preferable to control the viscosity to a low level. As a method for controlling viscosity to a low level, adding a solvent can be used as a simple method.

The method for forming the circumference adjustment layer (F) preferably comprises the steps of: applying a photosensitive resin composition (9) to a hollow cylindrical core material (A); photo-curing by irradiating with light; and adjusting the thickness of the obtained cured photosensitive resin layer. The method for applying the photosensitive resin composition (9) to a hollow cylindrical core material (A) is not especially limited. Examples of coating methods include commonly used methods, such as spray coating, blade coating, gravure coating, reverse-roller coating, kiss-touch coating, high-pressure air knife coating and the like. Rotating the hollow cylindrical core material (A) on its axis when applying the photosensitive resin composition (9) is effective for an even coating. In addition, the light source used for photo-curing of the formed photosensitive resin layer preferably generates beams which contain light of not less than 200 nm and not more than 450 nm. Examples include, but are not especially limited to, metal halide lamps, high-pressure mercury lamps, ultrahigh-pressure mercury lamps, carbon arc lamps, chemical lamps, germicidal lamps and the like. Light irradiation can be performed simultaneously with the application of the photosensitive resin composition, or may be performed after the application. Adjustment of the thickness of the cured photosensitive resin layer obtained from the light irradiation can be carried out by combining a cutting method using a blade such as the cutting tool of a lathe or the like; a cutting method using a rotating abrasive wheel; and a polishing method using an abrasive cloth. Of course, the treatment can also be carried out by fixing the long axis of the hollow cylindrical core material (A) while rotating in a circumference direction.

Adhesion with the circumference adjustment layer (F) can be increased by treating the surface of the hollow cylindrical core material (A). Examples of methods which can be used include thinly forming an adhesive layer on the surface of the hollow cylindrical core material (A), forming an adhesion-improving primer layer, and physically or chemically treating. Examples of a physical treating method include irradiating with high energy rays such as plasma, light in the vacuum ultraviolet range, an electron beam, an ion beam or the like; or exposing to an atmosphere of high energy rays and the like. A method which can be simply carried out is the irradiation with an excimer UV (172 nm wavelength) lamp. Examples of chemical treatments include oxidizing the surface of the hollow cylindrical core material (A) with a chemical solution. Specific examples of an "adhesion-improving primer layer" include a silane coupling agent, a titanium coupling agent, a silicone adhesive aid or the like, formed into a thin layer.

In the present invention a seamless circumference adjustment layer (F) which contains air bubbles can easily be formed on the hollow cylindrical core material (A). Incorporating air bubbles into the above-described circumference adjustment layer (F) allows the hollow cylindrical printing element to be made lighter. Air bubbles incorporated into the layer can be as a continuous air bubble, although from a mechanical strength viewpoint individual bubbles are more preferable. A continuous air bubble can be formed by mixing air or other such gases into the photosensitive resin composition (9), by mixing a compound which generates nitrogen from heat or light or by some other similar method. Closed cells can be formed by using hollow microparticles. Examples include inorganic hollow microparticles, such as hollow glass microparticles, hollow silica microparticles or the like, and organic microparticles in the form of microcapsules. Among organic microparticles, the use of thermo-expandable microcapsules whose volume expands as a result of heating is especially preferable. Since this type of thermo-expandable microcapsule comprises in its interior a volatile organic liquid, in the case of mixing into the photosensitive resin composition (9), light transmittance can be ensured which does not hinder the photo-curing properties. Therefore, by carrying out together the curing of the photosensitive resin composition (9) by light irradiation and the heat expansion of the thermo-expandable microcapsules from heating, photo-curing of a thick film becomes possible. In the case of mixing the hollow microparticles into the photosensitive resin composition, there is a large difference in the refractive index between the interior air layer and the photosensitive resin composition, which generally gives rise to a turbid state. However, even for such a turbid resin, a thick film photo-cured material can still be obtained by coating in a thin film state, and repeatedly carrying out the curing step while coating.

Production will now be explained of a circumference adjustment layer (F) which contains closed cells in the layer by using a photosensitive resin composition comprising the above-described thermo-expandable microcapsules. The thickness of a circumference adjustment layer (F) which has undergone heat-expansion is preferably in the range of 1.1 to 100 times the thickness prior to thermo-expanding the thermo-expandable microcapsules. More preferable is the range of 1.1 to 50 times. If 1.1 times or more, the lightening of the circumference adjustment layer (F) can be ensured. If 100 times or less, the mechanical strength of the circumference adjustment layer (F) can be obtained. The circumference adjustment layer (F) thickness is preferably observed by exposing a cross section and using a scanning electron microscope or an optical microscope.
The average size of the air bubbles having a partition wall which are present in the circumference adjustment layer (F) is preferably not less than 0.5 µm and not more than 500 µm. If 0.5 µm or more, the circumference adjustment layer (F) can be made lighter, and if 500 µm or less, it is possible to ensure the mechanical strength of even a circumference adjustment layer (F) only a few millimeters in thickness. The size of the air bubbles in the circumference adjustment layer (F) is preferably observed using an optical microscope or a laser confocal microscope.
The average value of the partition wall thickness is preferably not less than 0.05 µm and not more than 10 µm. If 0.05 µm or more, the air bubbles can be maintained, and if 10 µm or less, it is possible to ensure that the circumference adjustment layer (F) is made lighter. The thickness of the partition walls can be evaluated by cutting open the circumference adjustment layer (F) and observing the resulting cross-section with a high-resolution scanning electron microscope.

The thermo-expandable microcapsules are microparticles which use a thermoplastic elastomer as a partition wall, and contain in their interior a volatile organic liquid. The volume of such thermo-expandable microcapsules preferably expands by heating at between 60 and 250°C, and more preferably between 100 and 200°C. Examples of commonly used thermoplastic elastomers include polyvinylidene chloride, polyacrylonitrile, polymethyl methacrylate and the like. Examples of the volatile organic liquid include hydrocarbons such as butane, isobutane, butene, isobutene, pentane, isopentane, neopentane, hexane, heptene and the like. Use of thermo-expandable microcapsules enables closed cells to be formed which have a comparatively similar particle size when thermoexpanded. In addition, the partition walls may be applied with inorganic microparticles. Examples of inorganic microparticles include silica, calcium carbonate, titanium oxide and the like.
A preferred density range of the circumference adjustment layer (F) is not less than 0.1 g/cm³ and not more than 0.9 g/cm³, and more preferred is not less than 0.3 g/cm³ and not more than 0.7 g/cm³. If 0.1 g/cm³ or more, the mechanical strength of the circumference adjustment layer (F) can be ensured, and if 0.9 g/cm³ or less, it is possible to ensure that the circumference adjustment layer (F) is made lighter.

In cases where the photosensitive resin composition (9) does contain thermo-expandable microcapsules, if the photosensitive resin composition is completely cured it becomes difficult to thermo-expand the microcapsules. Thus, it is preferable to regulate the energy amount of the irradiated light so that the photosensitive resin composition is partially cured, and subsequently carry out a heat treatment to cause the thermo-expandable microcapsules to expand, and then again irradiate with light to thereby completely cure the photosensitive resin composition. Alternatively, in cases where there is a high content of thermo-expandable microcapsules, a circumference adjustment layer (F) having a predetermined thickness can be formed by thinly applying a photosensitive resin composition to the hollow cylindrical core material (A), and then once the thermo-expandable microcapsules have been expanded, repeatedly irradiating with light to complete the photo-curing. In addition, microcapsules which have already been made to expand can also be added into the photosensitive resin composition.

In the step of thermo-expanding a semi-cured photosensitive resin layer (g) containing thermo-expandable microcapsules which is formed on the hollow cylindrical core material (A), a preferable method for forming the circumference adjustment layer (F) with a uniform thickness is to pass the photosensitive resin layer (g), while in contact with a sheet-shaped or roll-shaped object (h), through the space between the hollow cylindrical core material (A) and the object (h) which is disposed at a set interval apart therefrom by rotating the hollow cylindrical core material (A) while heating the photosensitive resin layer (g). Examples of the heating method include, blowing a hot blast, irradiating with infrared rays, using a heater to heat the sheet-shaped or roll-shaped object (h) and the like. These methods may also be used together. Examples of methods for rapidly stopping the generation of bubbles from heating include cooling by blowing a cold blast, or by bringing into contact with a cold roll or cold sheet.

The photosensitive resin composition (9) for forming the circumference adjustment layer (F) according to the present invention preferably is a compound which comprises at least one kind of binder (i), an organic compound (j) having at least one kind of polymerizable unsaturated group, and at least one kind of photoinitiator (k). From the viewpoint of moldability, it is preferably in a liquid state at 20°C, whereby a seamless layer can be formed having a uniform thickness. Further, if the film having a thickness of molded is extremely thin, it is preferable to control the viscosity at a low level. As a method for controlling viscosity to a low level, adding a solvent is a simple method.

As the binder (i), a commonly known polymer compound can be used. Specific examples of preferred polymer compounds include rubber polymer compounds having rubber elasticity, such as a synthetic rubber, thermoplastic elastomers or the like; resins which are solid at 20°C, such as thermoplastic resins having a high elastic modulus; or resins which are a liquid at 20°C and have a polymerizable unsaturated group in the molecule, such as unsaturated polyurethane resins, unsaturated polyester resins, and liquid polybutadienes. Preferable examples of rubber polymer compounds include natural rubber, stryrene-butadiene rubber, acrylonitrile-butadiene rubber, polybutadiene rubber, polyisoprene rubber, ethylene-propylene rubber and polymers of a monovinyl-substituted aromatic hydrocarbon monomer and a conjugated diene monomer. Examples of monovinyl-substituted aromatic hydrocarbon monomers include styrene, α-methylstyrene, p-methylstyrene, and p-methoxystyrene; and examples of conjugated diene monomers include butadiene and isoprene and the like. Representative examples of thermoplastic elastomers include styrene-butadiene block copolymers and styrene-isoprene block copolymers. Examples of thermoplastic resins having a high elastic modulus include polycarbonate, polysulfone, polyethersulfone, polyetheretherketone, polyamide, polyamic acid, polyester, polyphenyleneether and the like. For a resin which is solid at 20°C, especially preferable are those which can dissolve in a solvent. A preferable range for the number average molecular weight of the binder (i) is not less than 1,000 and not more than 300,000, and more preferably is not less than 5,000 and not more than 100,000, and even more preferably is not less than 7,000 and not more than 50,000. "Number average molecular weight" according to the present invention is determined by GPC (gel permeation chromatography) in which polystyrene having a known molecular weight is used as a standard to calculate the value.

From the viewpoint of photo-curing the photosensitive resin in air, the binder (i) preferably comprises, either at least one kind of organic group in the molecule selected from the group consisting of an aryl group, a linear or branched alkyl group substituted with at least one aryl group, an alkyl group, an alkoxycarbonyl group, a hydroxyl group, and a formyl group; or has a carbonate bond or an ester bond, and comprises a hydrogen atom (α-position hydrogen atom) bonded to a carbon atom to which the organic group or the bond is directly bonded in an amount of 2% or more with respect to total hydrogen atoms in the molecule. While the reason is not clear, by using a compound having the above-described specific functional group, and whose organic group has a hydrogen atom bonded to a directly bonded carbon atom, a photosensitive resin compound is provided which is capable of photo-curing even in air. Preferable examples of the aryl group include a phenyl group, tolyl group, xylyl group, biphenyl group, naphthyl group, anthryl group, pyrenyl group, phenanthryl group and the like. Further, preferable examples of the linear or branched alkyl group substituted with an aryl group include a methylstyryl group, a styryl group and the like. The α site hydrogen content can be analyzed by nuclear magnetic resonance spectroscopy (¹H-NMR) focused on the hydrogen atoms.
The binder (i) component is preferably in the range of 10 to 90% by weight based on the nonvolatile component total weight of the photosensitive resin composition (9). More preferable is from 20 to 80% by weight, and still more preferable is from 30 to 69% by weight.

The organic compound (j) having a polymerizable unsaturated group contained in the photosensitive resin composition (9) is a compound which participates in a radical, addition, or ring-opening polymerization reaction. Commonly known compounds may be used therefor, and no particular limitations exist.
Examples of compounds which participate in a radical reaction include olefins, such as ethylene, propylene, styrene and divinylbenzene; acetylene type compounds; (meth)acrylic acid and derivatives thereof; haloolefins; unsaturated nitriles, such as acrylonitrile; (meth)acrylamide and derivatives thereof; unsaturated dicarboxylic acids (such as maleic anhydride, maleic acid and fumaric acid) and derivatives thereof; vinyl acetate; N-vinylpyrrolidone; and N-vinylcarbazole. From the viewpoint of availability of the various products and cost etc., (meth)acrylic acid and derivatives thereof are preferred. Examples of the derivatives include compounds having an aliphatic group, such as a cycloalkyl group, a bicycloalkyl group, a cycloalkenyl group or a bicycloalkenyl group; compounds having an aromatic group, such as a benzyl group, a phenyl group, a phenoxy group or a naphthalene skeleton, an anthracene skeleton, a biphenyl skeleton, a phenanthrene skeleton, a fluorene skeleton and the like; compounds having a group, such as an alkyl group, a halogenated alkyl group, an alkoxyalkyl group, a hydroxyalkyl group, an aminoalkyl group, or a glycidyl group; and esters with a polyol, such as an alkylene glycol, a polyoxyalkylene glycol, a polyalkylene glycol or a trimethylol propane; and compounds having a polysiloxane structure such as polydimethylsiloxane, polydiethylsiloxane and the like. Such examples may also include a heterocyclic aromatic compound containing nitrogen, sulfur or similar element.

Examples of polymerizable unsaturated groups which participate in an addition polymerization reaction include a cinnamoyl group, a thiol group, and an azido group. Further, examples of polymerizable unsaturated groups which participate in a ring-opening polymerization reaction include an epoxy group, an oxetane group, a cyclic ester group, a dioxysilane group, a spiro-o-carbonate group, a spiro-o-ester group, a bicyclo-o-ester group, a cyclosiloxane group and a cyclic iminoether group. Examples of compounds having a particularly useful epoxy group include compounds which are obtained by reacting epichlorohydrin with any of various polyols (such as diols and triols); and epoxy compounds obtained by reacting a peracid with an ethylenic bond in the molecule. Specific examples of such compounds include epoxy compounds such as ethylene glycol diglycidyl ether, diethylene glycol diglycidyl ether, triethylene glycol diglycidyl ether, tetraethylene glycol diglycidyl ether, polyethylene glycol diglycidyl ether, propylene glycol diglycidyl ether, tripropylene glycol diglycidyl ether, polypropylene glycol diglycidyl ether, neopentyl glycol diglycidyl ether, 1,6-hexanediol diglycidyl ether, glycerin diglycidyl ether, glycerin triglycidyl ether, trimethylol propane triglycidyl ether, bisphenol A diglycidyl ether, hydrogenated bisphenol A diglycidyl ether, diglycidyl ethers of a compound formed by addition-bonding ethylene oxide or propylene oxide to bisphenol A, polytetramethylene glycol diglycidyl ether, poly(propylene glycol adipate)diol diglycidyl ether, poly(ethylene glycol adipate)diol diglycidyl ether, poly(caprolactone)diol diglycidyl ether and the like; and an epoxy-modified silicone oil (HF-105^{™}; manufactured by Shin-Etsu Chemical Co., Ltd.).

To increase the mechanical strength of the circumference adjustment layer (F), it is preferred that at least one alicyclic or aromatic derivative is incorporated as the organic compound (j). It is preferred that such alicyclic or aromatic derivative is 20% by weight or more, and more preferably 50% by weight or more, of the total amount of the organic compound (j). Further, such aromatic derivatives may also be an aromatic compound containing nitrogen, sulfur or similar element.
The ratio for the binder (i) and organic compound (j) in the photosensitive resin composition (9) is, per 100 parts by weight of binder (i), preferably in the range of 5 to 200 parts by weight of organic compound (j), and more preferably from 20 to 100 parts by weight.

As the photoinitiator (k) contained in the photosensitive resin composition (9), a commonly known photoinitiator may be used. For example, known radical polymerization initiators such as aromatic ketones or benzoyl ethers can be used. Examples from among benzophenone, Michler's ketone, benzoin methyl ether, benzoin ethyl ether, benzoin isopropyl ether, α-methylol benzoin methyl ether, α-methoxy benzoin methyl ether and 2,2-dimethoxyphenylaceto-phenone can be used. Combinations of such compounds can also be used. Especially when carrying out the photo-curing in air, the combination of a hydrogen abstracting photoinitiator such as benzophenone and a degradable photoinitiator such as 2,2-dimethoxyphenylaceto-phenone is particularly preferable. Advantageous effects in photo-curing in air can also be seen by using a compound having in the same molecule a moiety which acts as a hydrogen abstracting photoinitiator and a moiety which acts as a degradable photoinitiator. Further examples include photocationic polymerization initiators which generate an acid by absorbing light, such as an aromatic diazonium salt, an aromatic iodonium salt and an aromatic sulfonium salt; or photoinitiators thereof which generate a base by absorbing light. The photoinitiator is preferably used in an amount of 0.01 to 10% by weight, based on the total weight of the binder (i) and organic compound (j).

As shown in Fig. 1, the present invention may also be a laminate body formed with a cushion layer (E) having cushioning properties provided between the circumference adjustment layer (F) (reference numeral 3) and a resin layer (B) (reference numeral 6) capable of forming a pattern on its surface or resin layer (C) (reference numeral 6) formed with a pattern on its surface. In cases where there is no circumference adjustment layer (F), the present invention may be a laminate body formed with a cushion layer (E) having cushioning properties provided between the hollow cylindrical core material (A) (reference numeral 2) and a resin layer (B) capable of forming a pattern on its surface or resin layer (C) formed with a pattern on its surface.
The cushion layer (E) formed on the circumference adjustment layer (F) or on the hollow cylindrical core material (A) can be formed by: gluing a cushion tape provided with an adhesive layer onto the circumference adjustment layer (F) or the hollow cylindrical core material (A) with the adhesive layer facing thereon; adhering rubber to the circumference adjustment layer (F) or the hollow cylindrical core material (A), and then curing by crosslinking with heat; or forming a cushion layer with rubber elasticity by forming a photosensitive resin composition on the circumference adjustment layer (F) or the hollow cylindrical core material (A), and then photo-curing. An example of a simple method for forming a seamless cushion layer is to photo-cure a photosensitive resin composition. Obviously, as explained above regarding the circumference adjustment layer (F), continuous air bubbles or closed cells can also be incorporated therein.
The hardness of the cushion layer (E) of the present invention is preferably not less than 10 degrees and not more than 70 degrees in terms of shore A hardness, more preferably not less than 10 degrees and not more than 60 degrees and even more preferably not less than 10 degrees and not more than 50 degrees. If measurement using a shore A hardness meter is difficult as a consequence of air bubbles being incorporated in the cushion layer (E), an ASKER-C hardness may be used as the hardness for the cushion layer (E). A preferred range for ASKER-C hardness is not less than 20 degrees and not more than 70 degrees, and more preferably not less than 20 degrees and not more than 60 degrees. The hardness of the cushion layer (E) is preferably lower than the hardness of the resin layer (B) capable of forming a pattern on its surface or resin layer (C) formed with a pattern on its surface.

In the present invention, a patternable resin layer (B) or patterned resin layer (C) can be stacked on the hollow cylindrical core material (A), the circumference adjustment layer (F) or the cushion layer (E). The method for forming the pattern can be by using a photoengraving technique wherein exposure and developing steps are performed; or by a laser engraving method in which uneven portions are formed by irradiating with laser light, whereby resin on the portions irradiated with laser light is removed. The laser engraving method in particular allows a pattern to be formed without having to undergo a developing step, and is thus preferable as a method for forming a pattern on a resin layer based on image data using a computer.
For applications with a normal printing plate, the hardness of the resin layer (B) or resin layer (C) is in a region of shore A hardness of 20 to 75 degrees. For applications such as embossing by forming an uneven pattern on the surface of paper, film or construction materials, or letter-press printing plate or dry offset printing plate, a comparatively hard material is required, in the region of 30 to 80 degrees in terms of shore A hardness.
In the present invention, if forming a laser-engravable cylindrical printing original plate, liquid-state debris generated during the laser engraving step can be absorbed for removal by incorporating an inorganic porous material (f) in the laser-engravable cured photosensitive resin layer (3). The pre-photo-cured photosensitive resin composition (10) preferably comprises a resin (d) having a number average molecular weight of not less than 1,000 and not more than 200,000, an organic compound (e) having a number average molecular weight of less than 1,000 and which has a polymerizable unsaturated group in the molecule, and an inorganic porous material (f).

The type for resin (d) may be an elastomer or a non-elastomer, and at 20°C may be a solid polymer or a liquid polymer. In the case of using a thermoplastic resin, such resin comprises 30% by weight or more, preferably 50% by weight or more and more preferably 70% by weight or more of the total polymer weight. If the thermoplastic resin content is 30% by weight or more, the resin is thoroughly liquefied from the laser beam irradiation, and is thus absorbed by the below-described inorganic porous material. However, if using a large resin whose softening temperature exceeds 300°C, since the temperature for molding into a cylinder will naturally increase as well, so that there is a danger that other organic materials may deteriorate or decompose. For this reason, it is preferable to use by application in which a resin which can dissolve in a solvent is in a dissolved state.
In particular, from a perspective of how easily the resin can be applied to a cylindrical resin plate, or susceptibility to decomposing due to heat, it is preferable to use as the resin (d) a polymer which is a liquid at 20°C. If a polymer which is a liquid at 20°C is used as the resin (d), the formed photosensitive resin composition will also be a liquid, whereby molding can be carried out at a low temperature.
The number average molecular weight of the resin (d) used in the present invention is preferably in the range of 1,000 to 200,000. A more preferable range is from 5,000 to 100,000. If the number average molecular weight is in the range of 1,000 to 200,000, the mechanical strength of the printing original plate can be ensured, and during the laser engraving the resin can be sufficiently melted or made to decompose. "Number average molecular weight" according to the present invention is determined by GPC (gel permeation chromatography) in which polystyrene having a known molecular weight is used as a standard to calculate the value.

If an inorganic porous material is used, liquid-state debris generated during irradiation with laser beams can be absorbed by the inorganic porous material for removal. As the photosensitive resin composition (10) to be used, preferred is a resin which is easily liquefied or decomposed. Preferred examples of resins which are easily decomposed include those which contain, as easily decomposable monomer units in their molecular chain, styrene, α-methylstyrene, α-methoxystyrene, acrylate esters, methacrylate esters, ester compounds, ether compounds, nitro compounds, carbonate compounds, carbamoyl compounds, hemiacetal ester compounds, oxyethylene compounds and alicyclic compounds. Representative examples of such easily decomposable resins include polyethers, such as polyethylene glycol, polypropylene glycol and polytetraethylene glycol; aliphatic polycarbonates; aliphatic carbamates; and other resins, such as poly(methyl methacrylate), polystyrene, nitrocelluose, polyoxyethylene, polynorbornene, hydrated polycyclohexadiene and polymers having a molecular structure (such as a dendrimer) containing many branched structures. Further, from a decomposability viewpoint, polymers having a plurality of oxygen atoms in the molecular chain are preferable. Among these, compounds having a carbonate group, a carbamate group or a methacrylic group in their polymer main chain have high heat decomposability, and are thus preferable. Examples include polymers having good heat decomposability such as a polyester or polyurethane synthesized using a (poly)carbonate diol or (poly)carbonate dicarboxylic acid as raw materials and a polyamide synthesized using a (poly)carbonate diamine as a raw material. Such polymers may contain a polymerizable unsaturated group on their main chain or side chains. In particular, when a reactive functional group such as a hydroxyl group, amino group or carboxyl group is contained in the terminal, it is easy to introduce a polymerizable unsaturated group into the main chain terminal.

There is no particular limitation with respect to the thermoplastic elastomers used in the present invention. Examples include styrene thermoplastic elastomers, such as SBS (polystyrene-polybutadiene-polystyrene), SIS (polystyrene-polyisoprene-polystyrene) and SEBS (polystyrene-polyethylene-/polybutyrene-polystyrene); olefin thermoplastic elastomers; urethane thermoplastic elastomers; ester thermoplastic elastomers; amide thermoplastic elastomers; and silicone thermoplastic elastomers. For improving the heat decomposability, use can be made of a polymer which is obtained by introducing a readily decomposable functional group which has high decomposability in a molecular skeleton, such as a carbamoyl group or a carbonate group, into its main chain. Further, a polymer having improved heat decomposability can be mixed in. Since a thermoplastic elastomer is fluidized by heating, such a fluidized thermoplastic elastomer can be mixed with the organic porous material used in the present invention. The term "thermoplastic elastomer" means a material which has the ability to flow by heating and be processed in the same manner as an ordinary thermoplastic plastic, and which exhibits rubber elasticity at room temperature. The molecular structure for such a thermoplastic elastomer contains a soft segment of polyether, rubber molecules or the like, and a hard segment for preventing plastic deformation at around room temperature as in the case of a vulcanized rubber. There are various types of hard segments, such as a frozen phase, a crystalline phase, a hydrogen bond and an ionic crosslink.

The type of thermoplastic elastomer may be selected depending on the use of printing plate. For example, in fields requiring solvent resistance, a urethane, ester, amide or fluoro type thermoplastic elastomer is preferred. In fields requiring heat resistance, a urethane, olefin, ester or fluoro type thermoplastic elastomer is preferred. Further, hardness can be varied greatly depending on the type of the thermoplastic elastomer.
There is no particular limitation with respect to the non-elastomer used in the thermoplastic resin. Examples include a polyester resin, an unsaturated polyester resin, a polyamide resin, a polyamideimide resin, a polyurethane resin, an unsaturated polyurethane resin, a polysulfone resin, a polyethersulfone resin, a polyimide resin, a polycarbonate resin and a wholly aromatic polyester resin.
The softening temperature of the thermoplastic resin is preferably in the range of not less than 50°C and not more than 300°C, more preferably not less than 80°C and not more than 250°C, and most preferably not less than 100°C and not more than 200°C. If the softening temperature is 50°C or more, such a resin can be handled at room temperature as a solid and, thus, a shaped article having a sheet shape or a cylindrical shape can be handled without being deformed. On the other hand, if the softening temperature is 300°C or less, when shaping into a cylindrical shape the thermoplastic resin does not have to be subjected to extremely high temperatures. Therefore, there is no danger of deterioration or decomposition of other compounds mixed therein. Measurement of the softening temperature according to the present invention is carried out using a dynamic viscoelastometer, and the softening temperature is defined as the initial temperature at which the viscosity of a resin changes drastically (the slope of the viscosity curve changes) when the temperature of the resin is elevated from room temperature.

The resin (d) may also be a resin which is soluble in a solvent. Specific examples include a polysulfone resin, polyethersulfone resin, epoxy resin, alkyd resin, polyolefin resin, polyester resin and the like.
In many cases the resin (d) will not contain a polymerizable unsaturated group, which is normally highly reactive, although a highly reactive, polymerizable unsaturated group may be included on a molecule chain terminal or side chain. When a polymer having a highly reactive, polymerizable unsaturated group is used, a printing original plate can be produced with very high mechanical strength. Particularly for polyurethane or polyester thermoplastic elastomers, the introduction of a highly reactive, polymerizable unsaturated group into the molecule is relatively easy. The expression, "into the molecule" as used here also encompasses cases where a polymerizable unsaturated group is bonded to the terminal of a polymer main chain, bonded to the terminal of a polymer side chain, or directly in the polymer main chain or side chain. For example, a polymerizable unsaturated group may be directly introduced into the terminal of the polymer. Another preferable method is to introduce a polymerizable unsaturated group by reacting a component having a molecular weight of several thousands which contains a plurality of reactive groups (such as a hydroxyl group, an amino group, an epoxy group, a carboxyl group, an acid anhydride group, a ketone group, a hydrazine group, an isocyanate group, an isothiocyanate group, a cyclic carbonate group, an ester group and the like) with a binder (e.g. a polyisocyanate having a hydroxyl group and an amino group) having a plurality of groups capable of binding to the reactive groups of the above-described component, to thereby adjust the molecular weight of the polymer and convert the terminals of the polymer into binder groups. Subsequently, an organic compound having a polymerizable unsaturated group is reacted with the group which reacts with the terminal binding group, whereby the polymerizable unsaturated group is introduced into the terminal.

The organic compound (e) has an unsaturated bond which participates in a radical polymerization reaction or in an addition polymerization reaction. Taking into consideration how easily the resin (d) can be diluted, the number average molecular weight is preferably less than 1,000. Preferred examples of functional groups having an unsaturated bond which participates in a radical polymerization reaction include a vinyl group, an acetylene group, an acryl group, a methacryl group and an allyl group. Preferred examples of functional groups having an unsaturated bond which participates in an addition polymerization reaction include a cinnamoyl group, a thiol group, an azido group, an epoxy group which participates in a ring-opening addition reaction, an oxetane group, a cyclic ester group, a dioxysilane group, a spiro-o-carbonate group, a spiro-o-ester group, a bicyclo-o-ester group, a cyclosiloxane group and a cyclic iminoether group.

Specific examples of organic compound (e) include olefins, such as ethylene, propylene, styrene and divinylbenzene; acetylene type compounds; (meth)acrylic acid and derivatives thereof; haloolefins; unsaturated nitriles, such as acrylonitrile; (meth)acrylamide and derivatives thereof; allyl compounds, such as allyl alcohol and allyl isocyanate; unsaturated dicarboxylic acids (such as maleic anhydride, maleic acid and fumaric acid) and derivatives thereof; vinyl acetate; N-vinylpyrrolidone; and N-vinylcarbazole. From the viewpoint of availability of the various products, cost, decomposability during laser beam irradiation and the like, (meth)acrylic acid and derivatives thereof are preferred. Examples of the derivatives include compounds having an aliphatic group, such as a cycloalkyl group, a bicycloalkyl group, a cycloalkyennyl group or a bicycloalkenyl group; compounds having an aromatic group, such as a benzyl group, a phenyl group, a phenoxy group or a naphthalene skeleton, an anthracene skeleton, a biphenyl skeleton, a phenantherene skeleton, a fluorene skeleton and the like; compounds having a group, such as an alkyl group, a halogenated alkyl group, an alkoxyalkyl group, a hydroxyalkyl group, an aminoalkyl group, or a glycidyl group; and esters with a polyol, such as an alkylene glycol, a polyoxyalkylene glycol, a polyalkylene glycol or a trimethylol propane; and compounds having a polysiloxane structure such as polydimethylsiloxane, polydiethylsiloxane and the like. Such examples may also include a heterocyclic aromatic compound containing nitrogen, sulfur or similar element.

Examples of compounds having an epoxy group which participate in a ring-opening addition polymerization reaction include compounds which are obtained by reacting epichlorohydrin with any of various polyols (such as diols and triols); and epoxy compounds obtained by reacting a peracid with an ethylenic bond in the molecule. Specific examples of such compounds include epoxy compounds and epoxy-modified silicone oils such as ethylene glycol diglycidyl ether, diethylene glycol diglycidyl ether, triethylene glycol diglycidyl ether, tetraethylene glycol diglycidyl ether, polyethylene glycol diglycidyl ether, propylene glycol diglycidyl ether, tripropylene glycol diglycidyl ether, polypropylene glycol diglycidyl ether, neopentyl glycol diglycidyl ether, 1,6-hexanediol diglycidyl ether, glycerin diglycidyl ether, glycerin triglycidyl ether, trimethylol propane triglycidyl ether, bisphenol A diglycidyl ether, hydrogenated bisphenol A diglycidyl ether, diglycidyl ethers of a compound formed by addition-bonding ethylene oxide or propylene oxide to bisphenol A, polytetramethylene glycol diglycidyl ether, poly(propylene glycol adipate)diol diglycidyl ether, poly(ethylene glycol adipate)diol diglycidyl ether, poly(caprolactone)diol diglycidyl ether and the like.

In the present invention, depending on the purpose, one or more organic compounds (e) having such a polymerizable unsaturated bond can be selected. For example, if using as a printing plate, it is preferred that the organic compound (e) has at least one long-chain aliphatic, alicyclic or aromatic derivatives in order to suppress swelling caused by the organic solvent used as a solvent for the printing ink (i.e., an organic solvent, such as an alcohol or an ester).
To increase the mechanical strength of the printing original plate obtained from the resin composition, it is preferred that the organic compound (e) has at least one alicyclic or aromatic derivative. In such case, it is preferred that such derivative is 20% by weight or more, and more preferably 50% by weight or more, of the total amount of the organic compound (e). Further, aromatic derivatives may also be an aromatic compound containing nitrogen, sulfur or similar element.
To increase the anti-springiness of the resin layer (B) or resin layer (C), the conventional technical knowledge concerning photosensitive resin compositions for printing may be applied, for instance using the methacrylic monomer described in JP-A-7-239548.

The inorganic porous material (f) is an inorganic microparticle comprising micropores in the particle, or comprising tiny voids. This material is an additive for absorbing and removing viscous liquid debris generated in large quantities during the laser engraving, and also has an effect of tack prevention on the plate surface. When it is intended to conduct the photo-curing with ultraviolet light or visible light, black microparticles, such as carbon black, activated carbon and graphite, are not suitable as the inorganic porous material (f) according to the present invention, but not excluded as a material in particular because other than not melting by laser beam irradiation, black particles cause a marked lowering of the transmission of light into the inner portion of the photosensitive resin composition, thereby lowering the properties of the hardened material.
The pore volume of the inorganic porous material (f) is in the range of not less than 0.1 ml/g and not more than 10 ml/g, and preferably not less than 0.2 ml/g and not more than 5 ml/g. When the pore volume is 0.1 ml/g or more, a satisfactory amount of the viscous liquid debris can be absorbed. On the other hand, when the pore volume is 10 ml/g or less, the mechanical properties of the particles can be ensured. In the present invention, measurement of the pore volume is conducted using a nitrogen adsorption method. The pore volume according to the present invention is determined from a nitrogen adsorption isotherm obtained at -196°C.

The average pore size of the inorganic porous material (f) has a great influence on how much liquid debris which is generated during the laser engraving can be absorbed. The average pore size is preferably in the range of not less than 1 nm and not more than 1,000 nm, more preferably not less than 2 nm and not more than 200 nm, and even more preferably not less than 2 nm and not more than 50 nm. If the average pore size of an inorganic porous material is 1 nm or more, its ability to absorb the liquid debris generated during the laser engraving is satisfactory. On the other hand, if the average pore size is 1,000 nm or less, the specific surface area of the particles is large, which ensures that a sufficient amount of liquid debris can be absorbed. The reason why the absorbed amount of liquid debris is small when the average pore size is less than 1 nm is not fully clear, but it is considered that since the liquid debris is viscous, it finds it difficult to enter into the micropores. Average pore size according to the present invention is a value measured using a nitrogen adsorption method. Pores having an average pore size of 2 to 50 nm are called "mesoporous pores". Porous particles having such mesoporous pores have a remarkably high ability to absorb liquid debris. The pore size distribution according to the present invention is determined from a nitrogen adsorption isotherm obtained at -196°C.

The present invention preferably employs a resin having a comparatively low molecular weight so that the resin can be easily cut by laser irradiation. For this reason, a large quantity of low molecular weight monomers and oligomers is generated when the molecules are cut. Therefore, the most notable characteristic of the present invention is the novel idea, which was completely unheard of until now, of using a porous inorganic absorbent for removing the viscous liquid debris. The physical characteristics of the inorganic porous material, such as a number average particle size, specific surface area, average pore size, pore volume, ignition loss and oil absorption value, are very important factors for achieving an efficient removal of the viscous liquid debris.
The inorganic porous material (f) preferably has a number average particle size of 0.1 to 100 µm. If a material is used which has a number average particle size smaller than this range, the original plate obtained from the resin composition of the present invention will be susceptible to dust flying around during the laser engraving. This not only contaminates the engraving apparatus, but also makes a rise in viscosity, entrance of air bubbles and generation of dust more likely to happen when performing the mixing of resin (d) and organic compound (e). On the other hand, if a material is used which has a number average particle size higher than this range, defects will more easily form in the relief image during the laser engraving, whereby the precision of a printed article will tend to more easily deteriorate. A more preferable number average particle size range is from 0.5 to 20 µm, and an even more preferable number average particle size range is from 3 to 10 µm. The number average particle size of the inorganic porous material used in the present invention can be measured using a laser scattering particle size distribution analyzer.

Further to evaluating the properties of the porous material, a new concept of "porosity" will now be introduced. The term "porosity" is defined as the ratio of specific surface area "P" to surface area "S" per unit weight calculated from average particle size "D" and the density "d" (units: g/cm³) of the matter constituting the particles (i.e. P/S). The surface area of one particle is πD² × 10⁻¹² (units: m²), and the weight of one particle is (πD³d/6) × 10⁻¹² (units: g). Thus, the surface area "S" per unit weight is S=6/(Dd) (units: m²/g). The specific surface area "P" is the value measured from nitrogen molecules being adsorbed on the surface.
The porosity of the inorganic porous material (f) is preferably 20 or more, more preferably 50 or more, and even more preferably 100 or more. If the porosity is at least 20, it is effective in absorbing and removing the liquid debris. Since the smaller the particles size becomes the bigger the specific surface area P is, specific surface area is unsuitable to be used alone as an index indicating the properties of a porous material. Thus, taking into consideration particle size, porosity has been adopted as a non-dimensional index. For example, carbon black, which is often used as a reinforcement material for rubber or the like, has an extremely large specific surface area of 150 m²/g to 250 m²/g. However, its average particle size is very small, usually being from 10 nm to 100 nm, so that if porosity is calculated with the same density of graphite of 2.25 g/cm², the value is in the range of 0.8 to 1.0. This would be thought of as being a non-porous material which did not have a porous structure in the particle interior. The above values were used for the density since it is generally known that carbon black has a graphite structure. In contrast, the porosity of the porous silica used in the present invention is a high value easily exceeding 500.

The inorganic porous material (f) used in the present invention preferably has a defined specific surface area and oil absorption value in order to obtain even better adsorption properties
The specific surface area of the inorganic porous material (f) is preferably in the range of not less than 10 m²/g and not more than 1,500 m²/g and more preferably not less than 100 m²/g and not more than 800 m²/g. If the specific surface area is 10 m²/g or more, the removal of liquid debris generated during laser engraving is sufficient, and if the specific surface area is 1,500 m²/g or less, the rise in the viscosity of the photosensitive resin composition can be suppressed, and the thixotropy can be controlled. Specific surface area in the present invention is determined by the BET method using a nitrogen adsorption isotherm obtained at -196°C.
The oil absorption value is an index for evaluating the amount of liquid debris that is absorbed. This is defined as an amount of oil absorbed by 100 g of an inorganic porous material. The oil absorption value of the inorganic porous material (f) used in the present invention is preferably in the range of not less than 10 ml/100 g and not more than 2,000 ml/100 g, more preferably not less than 50 ml/100 g and not more than 1,000 ml/100 g, and even more preferably not less than 200 ml/100 g and not more than 800 ml/100 g. If the oil absorption value is 10 ml/100 g or more, it is effective in removing liquid debris generated during the laser engraving. If the oil absorption value is 2,000 ml/100 g or less, the mechanical solution of the inorganic porous material (f) can be sufficiently ensured. Measurement of the oil absorption value is preferably determined in accordance with JIS-K5101.

The inorganic porous material (f) needs to retain its porous nature without deforming or melting particularly when subjected to laser beam irradiation in the infrared wavelength region. The ignition loss when treated for 2 hours at 950°C is preferably not more than 15% by weight, and more preferably not more than 10% by weight.
There is no particular limitation with respect to the particle shape of the inorganic porous material (f). Spheres, flat shapes, needle shapes, amorphous shapes or even particles having a projection on their surface can all be used. Among these examples, sphere-shaped particles are especially preferable from the viewpoint of abrasion resistance of the printing plate. Further, particles having a hollow particle interior or spherical granules, such as silica sponge, which have uniform pore diameter can also be used. Specific examples include, but are not limited to, porous silica, mesoporous silica, a silica-zirconia porous gel, a mesoporous molecular sieve, porous alumina, porous glass and the like.
In addition, pore size cannot be defined for substances such as a lamellar clay compound having voids of several nm to 100 nm between the layers and therefore, in the present invention the dimension of the void between the layers thereof (i.e., the distance between the layers) is defined as the pore diameter.
In addition, the total amount of the voids between the layers is defined as the pore volume. These values can be determined from a nitrogen adsorption isotherm.
Moreover, organic coloring matter such as pigments or dyes for absorbing light of a laser beam wavelength can be incorporated into these pores or voids.

"Sphericity" is defined as an index for classifying spherical particles. In the present invention, "sphericity" is defined as the ratio of (D₁/D₂), wherein D₁ represents the maximum value of the circle which is completely enclosed within a projected image of the particle and D₂ represents the minimum value of the circle which encloses the projected image. The sphericity of a true sphere is 1.0. It is preferred that the sphericity of a spherical particle used in the present invention is in the range of not less than 0.5 and not more than 1.0, more advantageously not less than 0.7 and not more than 1.0. If sphericity is 0.5 or more, abrasion resistance as a printing plate is good. A sphericity of 1.0 is the maximum value for sphericity. It is preferred that at least 70%, and more preferably at least 90%, of the particles have a sphericity of 0.5 or more. Sphericity can be determined by measuring based on a photograph taken under a scanning electron microscope. It is preferred that the photograph is taken at a magnification such that at least 100 particles can be observed on the monitor screen. While the above-mentioned D₁ and D₂ values are measure based on a photograph, it is preferable to use a scanner or the like to convert the photograph into digital data, and then process the obtained data using image analysis software.

Further, the surface of the inorganic porous material (f) may be modified by coating the surface thereof with a silane coupling agent, a titanium coupling agent or another organic compound, to thereby obtain particles having an improved hydrophilic or hydrophobic property.
In the present invention, the substances exemplified above as inorganic porous material (f) can be used individually or in combination of two or more. Adding the inorganic porous material (f) effectively suppresses the generation of liquid debris during laser engraving and improves the tack prevention of the relief patterned printing plate.
The ratio of resin (d), organic compound (e) and inorganic porous material (f) in the photosensitive resin composition (10) of the present invention is in general, relative to 100 parts by weight of resin (d), 5 to 200 parts by weight of organic compound (e), preferably 20 to 100 parts by weight; and 1 to 100 parts by weight, preferably 2 to 50 parts by weight, more preferably 2 to 20 parts by weight of inorganic porous material (f).
If the ratio of organic compound (e) is in the above range, it is easy to obtain a good balance between hardness and tensile strength of the resultant printing plate, lower shrinkage during the crosslink-curing, and adequate thickness accuracy cab be secured.
If the amount of inorganic porous material (f) is in the above range, effects such as tack prevention of the plate surface and suppression of generation of the liquid debris during laser engraving can be sufficiently exhibited. Further, the mechanical strength of the printing plate can be ensured, and transmittance can be maintained. Especially when used as a flexographic printing plate, hardness can be suppressed so as not be become too hard. When a laser-engravable printing original plate is formed by photo-curing a photosensitive resin composition with light, especially with UV light, the light transmittance influences the curing reaction. Therefore, it is advantageous to use an inorganic porous material whose refractive index is close to that of the photosensitive resin composition.

The photosensitive resin composition (10) is crosslinked by light irradiation to exhibit properties of the printing or the like. In this case, a polymerization initiator may be added. The polymerization initiator can be selected from among those generally employed, such as the radical polymerization initiators, cationic polymerization initiators and anionic polymerization initiators exemplified in "Koubunshi Deta Handobukku - Kisohen (Polymer Data Handbook -Fundamentals)", published in 1986 by Baifukan Co., Ltd. Crosslinking by photopolymerization using a photoinitiator is effective for improving the productivity of the printing original plate according to the present invention while maintaining the storage stability of the resin composition of the present invention. Commonly known initiators may be used as the initiator at such stage. Examples include benzoin; benzoin alkyl ethers, such as benzoin ethyl ether; acetophenones, such as 2-hydroxy-2-methylpropiophenone, 4'-isopropyl-2-hydroxy-2-methylpropiophenone, 2,2-dimethoxy-2-phenylacetophenone and diethoxyacetophenone; photoradical initiators, such as 1-hydroxycyclohexyl phenyl ketone, 2-methyl-1-[4-(methylthio)phenyl]-2-morpholino-propane-1-one, methyl phenylglyoxylate, benzophenone, benzyl, diacetyl, diphenylsulfide, eosin, thionine and anthraquinone; and photocationic polymerization initiators, such as an aromatic diazonium salt, an aromatic iodonium salt and an aromatic sulfonium salt, each of which generates an acid by absorbing light, or polymerization initiators thereof which generate a base by absorbing light. The polymerization initiator is preferably used in an amount of 0.01 to 10% by weight of the total weight of the resin (d) and organic compound (e).

In addition, depending on the use and intended purpose, other additives, such as a polymerization inhibitor, an ultraviolet absorber, a dye, a pigment, a lubricant, a surfactant, a plasticizer and a fragrance, may be added to the photosensitive resin composition (10).
With respect to the method for shaping the photosensitive resin composition (10) into a cylindrical shape, any conventional shaping method can be employed. Examples include a casting method; a method in which a resin is extruded from a nozzle or a die by using a machine such as a pump or an extruder, followed by adjustment of the thickness of the extruded resin using a blade, after which the resultant product is calendar processed using a roll, to thereby obtain a desired thickness. During the shaping, the resin can be heated at a temperature which does not cause the lowering of the properties of the resin. Further, if desired, the shaped resin may be subjected to a treatment using a pressure roll or an abrasion treatment. Further, after the photosensitive resin composition (10) has been applied to in a cylindrical shape, the printing plate can be formed in an apparatus for curing and solidifying the photosensitive resin composition (10) by irradiating with light using a cylindrical printing original plate molding/engraving apparatus which is equipped with a laser light source for laser engraving. If such an apparatus is used, after the cylindrical printing original plate has been formed, the printing plate can be formed by immediately subjecting to laser engraving. It thus becomes possible to carry out the operation in a short period of time which would have been unheard of with a conventional rubber sleeve which requires several weeks to conduct the shaping operation. In the process of producing a hollow cylindrical printing original plate, the use of a photosensitive resin composition (10) allows production of the hollow cylindrical printing original plate to be conducted in a very short period of time.

Adhesion with the circumference adjustment layer (F) can be improved by physically or chemically treating the surface of the hollow cylindrical core material (A) used in the present invention. Further, adhesion between the circumference adjustment layer (F) and the laser-engravable cured photosensitive resin layer (3) can be improved in the same manner. Examples of physical treatment methods include a sand blast method, a wet blast method (in which a liquid containing microparticles is sprayed), a corona discharge treatment, a plasma treatment, an ultraviolet light irradiation or vacuum ultraviolet light irradiation method and the like. Examples of chemical treatment methods include treatment with a strong acid, a strong alkali, an oxidation agent or a coupling agent.
The shaped photosensitive resin composition (10) forms a laser-engravable printing original plate by being irradiated with light or an electron beam to undergo crosslinking. The irradiation with light or an electron beam to undergo crosslinking can also be conducted while shaping. Crosslinking methods which use light are suitable as they have the advantage of having a simple apparatus and being able to form a thickness with high accuracy. Light sources which may be used in the curing include high-pressure mercury lamps, ultrahigh-pressure mercury lamps, ultraviolet fluorescent lamps, carbon arc lamps, xenon lamps and the like. Additionally, other commonly known methods may also be used to carry out the curing. Irradiation with light from a plurality of light source types can also be performed. When curing a photosensitive resin composition with light, a transparent cover film can be covered over the surface and irradiated with light such that oxygen is blocked out. The cover film can also be used to protect the surface of the printing original plate, although it should be peeled off during laser engraving. A gaseous atmosphere, especially atmospheric air, is preferable for the atmosphere in which the photosensitive resin composition layer is irradiated with light. This is because there is no need to mount a coating mechanism of the cover film for blocking oxygen or an oxygen deficiency prevention mechanism on the equipment when using an inert gas.

The thickness of the laser-engravable cured photosensitive resin layer (3) can be freely selected depending on the intended use thereof. When used as a printing plate, the thickness is generally in the range of 0.1 to 7 mm. In some cases a layers made of different materials may be multiply stacked.
The resin layer (C) formed with a pattern on its surface used in the present invention may be a photosensitive resin layer on which portions irradiated with the beam from a mask exposure system or a high energy scanning exposure system have been cured, a latent image has been formed after which uncured portions were removed by a developing process. A method can also be employed wherein a thin layer comprising a black pigment such as carbon black (a so-called "black layer) formed on the surface of a photosensitive resin composition, and a pattern is subsequently formed using a near-infrared laser, whereby this pattern is used as the exposure mask. Further, in the developing process, a developing liquid can also be used in which uncured resin dissolves or disperses. In addition, a heat-developing method can also be used which sucks up with a cloth after dissolving with heat, without the use of a developing liquid. A "mask exposure system" is a method which irradiates a photosensitive resin with a beam containing light having a wavelength of 200 nm to 450 nm through a negative film having a light-blocking pattern. A "high energy scanning exposure system" is a method which scans ultraviolet laser light or beam-like energy such as an electron beam using an optical system such as a Galvano mirror or an electron lens, to thereby irradiate with the photosensitive resin.

The surface-patterned resin layer (C) may be adhered via an adhesive layer or a pressure-sensitive adhesive to the hollow cylindrical core material (A), circumference adjustment layer (F), cushion layer (E), or rigid body layer (G).
As shown in Fig. 1, the present invention may also comprise a rigid body layer (G) (reference numeral 5 in the figure) which is not less than 0.01 mm and not more than 0.5 mm in thickness between the cushion layer (E) (reference numeral 4 in the figure), a patternable resin layer (B) or patterned resin layer (C) (reference numeral 6 in the figure). A preferable range for the linear thermal expansion coefficient of the rigid body layer (G) is not less than -10 ppm/°C and not more than 150 ppm/°C, and more preferably not less than 0 ppm/°C and not more than 100 ppm/°C when measuring by thermomechanical measurement (TMA) in a temperature range of 20°C to 80°C. If the linear thermal expansion coefficient is in the above range, the advantageous effects on fine lines during printing and suppression of ink adherence defects of fine characters can be seen.
In the present invention, as described above, a hollow cylindrical printing element can be produced by successively photo-curing and stacking a plurality of photosensitive resin composition layers. In addition, a hollow cylindrical printing element can also be produced by photo-curing in one turn once the plurality of photosensitive resin composition layers have been stacked.

The hollow cylindrical core material (A), circumference adjustment layer (F), cushion layer (E), rigid body layer (G), resin layer (B) which can form a pattern by laser engraving and patterned resin layer (C), are preferably formed by the photo-curing of a photosensitive resin composition. The polymerizable unsaturated groups present in the photosensitive resin composition are formed into a three-dimensional crosslinked structure by a reaction, and the resultant structure becomes insoluble in the conventionally used solvents, such as esters, ketones, aromatic compounds, ethers, alcohols and halogenated solvents. This reaction involves a reaction between polymerizable unsaturated groups, thus consuming the polymerizable unsaturated groups. When the resin composition is crosslink-cured using a photoinitiator, the photoinitiator is decomposed by light. The unreacted photoinitiator and the decomposition products thereof can be identified by extracting the crosslink-cured product with a solvent and analyzing the extracted product by GC-MS (a method in which products separated by gas chromatography are analyzed by mass spectroscopy), LC-MS (a method in which products separated by liquid chromatography are analyzed by mass spectroscopy), GPC-MS (a method in which products separated by gel permeation chromatography are analyzed by mass spectroscopy), or LC-MS (a method in which products separated by liquid chromatography are analyzed by nuclear magnetic resonance spectroscopy). Further, from analysis of the above-mentioned solvent extract by GPC-MS, LC-MS or GPC-NMR, it is also possible to identify the unreacted components in the solvent extract, as well as the formed products having a comparatively low molecular weight obtained by the polymerizable unsaturated groups reacting. With respect to a high molecular weight component which has a three-dimensionally crosslinked structure and is insoluble in the solvent, thermal gravimetric GC-MS can be used to confirm the presence of sites formed by the reaction between the polymerizable unsaturated groups as the components constituting the high molecular weight materials. For example, the presence of a site whose polymerizable unsaturated group reacted, such as a methacrylate group, an acrylate group, a vinyl group and the like, can be confirmed from the mass spectrum pattern. Thermal gravimetric GC-MS is a method in which a sample is decomposed by heat to thereby generate gas, and the generated gas is separated into its components by gas chromatography, followed by mass spectroscopic analysis of the separated components. When a degradation product derived from a photoinitiator unreacted photoinitiator is detected in the crosslink-cured product together with the unreacted polymerizable unsaturated groups or sites formed by a reaction between the polymerizable unsaturated groups, it can be concluded that the analyzed product is a substance obtained by photo-curing a photosensitive resin composition.

The amount of the inorganic porous microparticle contained in a crosslinked hardened material can be determined by heating the crosslinked hardened material in air, thereby burning off the organic components, and measuring the weight of the residual product. Further, the existence of inorganic porous microparticle in the residual product can be determined by observation of the shape under a field emission high resolution scanning electron microscope, measurement of the particle size distribution by a laser scattering particle size distribution analyzer, and measurements of the pore volume, pore size distribution and specific surface area by a nitrogen adsorption method.

In laser engraving, a desired image is converted into digital data, and a relief image is formed on the original plate by controlling a laser apparatus with a computer. The laser used for the laser engraving may be any type of laser so long as the laser comprises light having a wavelength which can be absorbed by the original plate. For performing the laser engraving quickly, it is preferred that the output of the laser is high. Some preferred examples include lasers having an oscillation wavelength in an infrared or near-infrared range, such as a carbon dioxide laser, a YAG laser, a semiconductor laser and a fiber laser. Further, ultraviolet lasers having an oscillation wavelength in an ultraviolet light range, such an excimer laser, a YAG laser tuned to the third or fourth harmonics and a copper vapor laser, may be used for an abrasion treatment (which breaks the linkages in the organic compounds) and hence, are suitable for fine operations. Lasers having a very high peak power such as a femtosecond laser, can also be used. The laser irradiation may be either a continuous irradiation or a pulse irradiation. In general, resins absorb a carbon dioxide laser having a wavelength around 10 µm, and so there is no need to add a component for facilitating the absorption of the laser beam. However, when a YAG laser, a semiconductor laser and a fiber laser which have an oscillation wavelength of around 1 µm is used, since most organic compounds do not absorb light having such a wavelength, it is preferable to add a component, such as a dye or a pigment, for facilitating absorption. Examples of dyes include a poly(substituted)-phthalocyanine compound and a metal-containing phthalocyanine compound, a cyanine compound, a squalilium dye, a chalcogenopyryloallylidene dye, a chloronium dye, a metal thiolate dye, a bis(chalcogenopyrylo)polymethine dye, an oxyindolidene dye, a bis(aminoaryl)polymethine dye, a melocyanine dye and a quinoid dye. Examples of pigments include dark colored inorganic pigments, such as carbon black, graphite, copper chromite, chromium oxide, cobalt chromium aluminate and iron oxide; powders of metals, such as iron, aluminum, copper and zinc, and doped metal powders which are obtained by doping any of the above-mentioned metal powders with Si, Mg, P, Co, Ni, Y or the like. These dyes and pigments can be used individually or in combination, and can also be combined in any form such as a bilayer structure. However, when the photosensitive resin composition is cured with ultraviolet or visible light, in order to cure as far as the inner portion of the printing original plate, it is preferred to avoid the use of pigments or dyes which absorb light in the light region.

The laser engraving can be performed in an oxygen-containing gas atmosphere, generally in the presence of or under the flow of air. However, it can also be performed in an atmosphere of carbon dioxide gas or nitrogen gas. After completion of the laser engraving, powdery or liquid substances which are present in a small amount on the surface of the resultant relief printing plate may be removed by an appropriate method, such as washing with a mixture of water with a solvent or surfactant, high pressure spraying of an aqueous detergent or spraying of a high pressure steam.
In the present invention, after the uneven pattern has been formed, a post-exposure operation can be performed, in which the surface of the patterned printing plate is irradiated with light having a wavelength of 200 nm to 450 nm. This is a method which is effective in removing surface tack. The post-exposure operation can be performed in air, under an inert gas atmosphere or in an aqueous environment. This is particularly effective when a hydrogen abstracting photoinitiator is contained in the photosensitive resin composition. Further, the printing plate surface prior to the post-exposure operation may be exposed by treating with a treating solution which comprises a hydrogen abstracting photoinitiator. The post-exposure operation can also be carried out by dipping the printing plate in a treating solution which comprises a hydrogen abstracting photoinitiator
The original plate according to the present invention can be applied or utilized in various uses, not only in a relief image for a printing plate, but also in a stamp and seal; a design roll for embossing; a relief image used for the patterning of insulating material, resistive material, or conductive material pastes used in the production of electronic parts; a relief image for the mold material used for producing potteries; a relief image for an advertisement or display board; and molds for various molded articles.

### EXAMPLES

The present invention will now be explained based on the following Examples, although the present invention is not limited thereto.

### (1) Laser Engraving

Laser engraving was performed using a carbon dioxide laser engraver (ZED-mini-1000^{™}; manufactured by ZED Instruments, Great Britain). The engraving was carried out by producing a pattern which included halftone dots, a line drawing formed from 500 urn-wide ridges, and 500 µm-wide reverse lines. If the engraving is set at a large depth, the top portion surface area of the fine halftone dot portion pattern cannot be properly obtained, and the shape also breaks down and becomes ill-defined. For this reason, the engraving depth was set at 0.55 mm.

### (2) Shape of the Halftone Dot Portions

Among the engraved portions, the shape of the halftone dot portions having a surface area ratio of approximately 10% at 80 lpi (lines per inch) were observed at 200 to 500 times magnification using an electron microscope. Halftone dots having a cone shape or pseudo-cone shape (i.e., a bell-bottom shape wherein a cone has been cut off near its apex across a plane parallel to the bottom of the cone) are good as printing plates.

### (3) Pore Volume, Average Pore Diameter and Specific Surface Area of a Porous or Non-Porous Material

2 g of a porous or non-porous material was placed in a test tube and vacuum-dried for 12 hours by a pretreatment apparatus at 150°C under 1.3 Pa or less. The pore volume, average pore diameter and specific surface area of the dried porous or non-porous material were measured using Autosorb-3 MP^{™} manufactured by Quantachrome Instruments, U.S.A., wherein nitrogen gas was adsorbed under an atmosphere at a liquid nitrogen temperature. Specifically, the specific surface area was calculated by the BET formula. With respect to the pore volume and average pore diameter, a cylindrical model was postulated from the adsorption isotherm during the desorption of nitrogen for calculation by the BJH (Brrett-Joyner-Halenda) method which is a pore distribution analysis method.

### (4) Ignition Loss of the Porous or Non-Porous Material

The weight of the porous or non-porous material to be measured was recorded. Subsequently, the sample to be measured was placed in a high temperature electric furnace (FG31 model^{™}; manufactured by Yamato Scientific Co., Ltd., Japan) and then treated in air at 950°C for 2 hours. The difference in weight after treatment was defined as the ignition loss.

### (5) Average Particle Size of the Microparticles

Measurement of the porous or non-porous material average particle size was performed using a laser diffraction particle size distribution analyzer (SALD-2000J^{™}; manufactured by Shimadzu Corporation, Japan). According to the device's catalogue, this analyzer is capable of measuring the particle size in the range of 0.03 µm to 500 µm. A measuring solution was prepared using methyl alcohol as a dispersion medium by bombarding ultrasonic waves for about 2 minutes to disperse the particles.

### (6) Viscosity

The viscosity of the photosensitive resin composition was measured using a B type viscometer (B8H model^{™}; manufactured by Tokyo Keiki Co., Ltd., Japan) at 20°C.

### (7) Measurement of Number Average Molecular Weight

The number average molecular weight of resin (a) was calculated using known-molecular-weight polystyrene by gel permeation chromatography (GPC). Measurement was carried out using a high performance GPC apparatus (HLC-8020; manufactured by Tosoh Corporation, Japan) and a polystyrene-packed column (TSKgel GMHXL^{™}; manufactured by Tosoh Corporation, Japan) wherein tetrahydrofuran (THF) was used as a carrier. The column temperature was set at 40°C. A THF solution containing 1% by weight of the resin was prepared as a sample, and 10 µl of this prepared sample was charged into the GPC apparatus. An ultraviolet absorption detector was used as a detector for resin (a), wherein light having a wavelength of 254 nm was used as the monitoring light.

### (8) Measurement of the Number of Polymerizable

### Unsaturated Groups

The average number of polymerizable unsaturated groups present in a synthesized resin (a) molecule was determined by removing the unreacted low molecular weight components using liquid chromatography, and then using nuclear magnetic resonance spectroscopy (NMR) to analyze the molecular structure.

### (9) Measurement of Shore D Hardness

The shore D hardness of the circumference adjustment layer (F) was measured using a GS-720G Type D^{™} manufactured by Teclock. The value immediately after starting measurement was used for the shore D hardness. The shore D hardness of the cylindrical core material (A) formed on a cylindrical support was measured as mounted on the cylindrical support. The deadweight used in the measurement was 8 kg.

### (10) Measurement of Linear Thermal Expansion Coefficient

The linear thermal expansion coefficient of the film-like reinforcement material was carried out by thermomechanical measurement (TMA). The measuring temperature range was from room temperature to 80°C, and a thermomechanical measuring apparatus (TMA-50^{™}; manufactured by Shimadzu Corporation) was employed.

### (Production Examples of Patternable Photosensitive Resin Compositions)

As resin (d), resins (d1), (d2) and (d3) were produced in the following Production Examples 1 to 3.

### (Production Example 1)

A 1-liter separable flask equipped with a thermometer, a stirring device and a reflux system was charged with 447.24 g of a polycarbonate diol manufactured by Asahi Kasei Corporation (PCDL L4672^{™}; number average molecular weight of 1,990; OH number 56.4) and 30.83 g of tolylene diisocyanate. The resultant mixture was reacted for about 3 hours under heating at 80°C, and then charged with 14.83 g of 2-methacryloyloxy isocyanate. This mixture was further made to react for about 3 hours, to thereby produce a resin (d1) having a methacrylic group on a terminal (an average of about 2 polymerizable unsaturated groups per molecule) and whose number average molecular weight was about 10,000. This resin was like a starch syrup at 20°C, and would flow if applied with an external force, but would not return to its original form when the external force was removed.

### (Production Example 2)

A 1-liter separable flask equipped with a thermometer, a stirring device and a reflux system was charged with 447.24 g of a polycarbonate diol manufactured by Asahi Kasei Corporation (PCDL L4672^{™}; number average molecular weight of 1,990; OH number 56.4) and 30.83 g of tolylene diisocyanate. The resultant mixture was reacted for about 3 hours under heating at 80°C, and then charged with 7.42 g of 2-methacryloyloxy isocyanate. This mixture was further made to react for about 3 hours, to thereby produce a resin (d2) having a methacrylic group on a terminal (an average of about 1 polymerizable unsaturated group per molecule) and whose number average molecular weight was about 10,000. This resin was like a starch syrup at 20°C, and would flow if applied with an external force, but would not return to its original form when the external force was removed.

### (Production Example 3)

A 1-liter separable flask equipped with a thermometer, a stirring device and a reflux system was charged with 449.33 g of a polycarbonate diol manufactured by Asahi Kasei Corporation (PCDL L4672^{™}; number average molecular weight of 1,990; OH number 56.4) and 12.53 g of tolylene diisocyanate. The resultant mixture was reacted for about 3 hours under heating at 80°C, and then charged with 47.77 g of 2-methacryloyloxy isocyanate. This mixture was further made to react for about 3 hours, to thereby produce a resin (d3) having a methacryl group on a terminal (an average of about 2 polymerizable unsaturated groups per molecule) and whose number average molecular weight was about 3,000. This resin was like a starch syrup at 20°C, and would flow if applied with an external force, but would not return to its original form when the external force was removed.

### (Formation of a Hollow Cylindrical Core Material)

A photosensitive resin compound (XI) which was a liquid at 20°C was obtained by mixing together: as resin (a) 100 parts by weight of the obtained resin (d1); as organic compound (b) 25 parts by weight of phenoxyethyl methacrylate (molecular weight: 206), 5 parts by weight of polypropylene glycol monomethacrylate (molecular weight: 400), and 10 part by weight of trimethylolpropane trimethacrylate (molecular weight: 339); as a photoinitiator 0.6 part by weight of 2,2-dimethoxy-phenylacetophenone and 1 part by weight of benzophenone; and as other additives 0.5 part by weight of 2,6-di-t-butylacetophenone.
A 125 pm-thick PET film was wound around the surface of an air cylinder having an outer dimension of 213.384 mm which had been thinly coated with polydimethylsiloxane as mold release agent. The PET film was positioned so that the gap formed where both end portions met was no greater than 0.5 mm, and then provisionally held. A 25 mm-wide and 0.13 mm-thick glass cloth tape on which an adhesive had been applied to one side was wound in a spiral shape around this PET film, whereby the PET film was covered to thereby provide a cylindrical laminate body.
Using a doctor blade, the liquid photosensitive resin compound (XI) was applied to the surface of the cylindrical laminate body covered with glass cloth tape while rotating the air cylinder, so that a photosensitive resin composition layer was formed to have a total laminate thickness of approximately 2 mm as measured from the surface of the PET film. In addition, while rotating the air cylinder in a circumferential direction, irradiation with light from a metal halide lamp (M056-L21^{™}; manufactured by Eye Graphics Co., Ltd.) was performed at 4,000 mJ/cm² (value obtained by integrating the luminance measured using a UV meter (UV-M02^{™}; manufactured by ORC Manufacturing Co., Ltd.) and a UV-35-APR filter) with time, to thereby obtain a cured photosensitive resin layer. The lamp luminance on the surface of the photosensitive resin composition layer was measured using a UV meter (UV-M02^{™}; manufactured by ORC Manufacturing Co., Ltd.). The lamp luminance measured using the filter UV-35-APR filter^{™} (manufactured by ORC Manufacturing Co., Ltd.) was 100 mW/cm². The lamp luminance measured using the filter UV-25 filter^{™} (manufactured by ORC Manufacturing Co., Ltd.) was 14 mW/cm². A carbide tool was then used to cut to a thickness of 1.5 mm. A cutting grind stone was used to rough-cut the surface, after which a film whose surface had a fine grind stone adhered thereto was used for fine polishing, to thereby obtain a hollow cylindrical core material (α). The shore D hardness of the obtained hollow cylindrical core material (α) was 55 degrees. Further, the surface difference of elevation measured using a contact displacement sensor (trademark: "AT3-010"; manufactured by Keyence Corporation) was within 20 µm. The time taken to fabricate the hollow cylindrical core material (α) was less than 30 minutes.

A liquid photosensitive resin composition (XII) was further prepared in which 1 part by weight of benzophenone was mixed with 99 parts by weight of a liquid photosensitive resin composition (APR-G-42^{™}; manufactured by Asahi Kasei Chemicals Corporation).
The liquid photosensitive resin composition (APR-G-42^{™}; manufactured by Asahi Kasei Chemicals Corporation) is a resin comprising an unsaturated polyurethane resin, an organic compound having several types of polymerizable unsaturated groups, and a photoinitiator.
The photosensitive resin composition (XII) used in Example 1 was impregnated into a nylon mesh sheet (150 mesh) formed from nylon fibers woven lengthwise and crosswise that was 110 µm-thick and whose dimension of the aperture portions was about 60 µm. After excess photosensitive resin composition had been removed with a blade, irradiation with light from a chemical lamp (central wavelength: 370 nm) was performed in air at 50 mJ/cm², to thereby form a cured photosensitive resin in a semi-cured state. Adhesiveness remained on the surface. Measurement of surface tack was, at more than 200 N/m, large.
The nylon mesh sheet containing the semi-cured cured photosensitive resin was doubly wound in a spiral shape around a PET film covering an air cylinder having an outer dimension of 213.384 mm. Next, using a doctor blade, the photosensitive resin compound (XII) was applied to the nylon mesh sheet, to thereby form a photosensitive resin composition layer. A cured photosensitive resin was then obtained by irradiating with light from a metal halide lamp. The thickness of the obtained cured photosensitive resin layer formed an approximately 1.5 mm-thick hollow cylindrical core material (β). The shore D hardness of the formed hollow cylindrical core material (β) was 60 degrees. Further, the surface unevenness difference of elevation was 100 µm. The time taken to produce the hollow cylindrical core material (β) was less than 30 minutes.
A photosensitive resin composition (XIII) was prepared in which 5 parts by weight of silicon nitride spherical microparticles having an average particle size of 5 µm were mixed with 100 parts by weight of the photosensitive resin composition (XII). The silicon nitride spherical microparticles were observed with a scanning electron microscope that showed that 90% or more of the particles had a sphericity of at least 0.8.
The photosensitive resin compound (XIII) was applied with a doctor blade to a mold-release-treated air cylinder having an outer dimension of 213.384 mm. Curing was achieved by irradiating with light from a metal halide lamp, whereby a resin layer (D) was formed.
The photosensitive resin composition (XII) was again impregnated into a nylon mesh sheet. Irradiation with light from a chemical lamp was performed in air at 50 mJ/cm², whereby a semi-cured cured photosensitive resin was obtained. Adhesiveness remained on the surface.
After the obtained semi-cured cured photosensitive resin had been wound around the resin layer (D) while being pressed with a roller, irradiation with light from a metal halide lamp was performed at 4,000 mJ/cm², to thereby form a cured photosensitive resin layer constituting a hollow cylindrical core material on which the nylon mesh sheet was triply wound around. The shore D hardness of the hollow cylindrical core material (γ) consisting of the obtained cured photosensitive resin layer was high at more than 60 degrees.

### (Formation of the Circumference Adjustment Layer)

The thickness of the circumference adjustment layer was determined by reverse-calculation from the thickness of the material to be used with an air cylinder having a 213.384 mm outer dimension in the case of designing the printing plate circumference to be 700 mm. For example, if setting the thickness of the laser-engravable cured photosensitive resin layer to be 1.14 mm, the thickness of the cushion tape with an adhesive layer on both sides to be 0.55 mm (adhesive layer thickness for one side being 25 µm) and the thickness of the hollow cylindrical core material to be 1.50 mm, the preset value for the thickness of a circumference adjustment layer would be 1.526 mm.
1 part by weight of methylstyryl-modified silicone oil (KF 410^{™}; manufactured by Shin-Etsu Chemical Co., Ltd.) was charged and mixed with 99 parts by weight of the above-described photosensitive resin composition. The photosensitive resin composition (XIV) was prepared for use in circumference adjustment layer (α) production.
The photosensitive resin composition (XIV), which was a liquid at 20°C, was applied in a thickness of 1.1 mm using a doctor blade to a 213.384 mm inner diameter, 300 mm wide hollow cylindrical core material produced obtained as described above. The resultant product was then irradiated in a nitrogen atmosphere with light from a metal halide lamp (M056-L21^{™}; manufactured by Eye Graphics Co., Ltd.) at 4,000 mJ/cm² (value obtained by integrating with time of the luminance measured using a UV meter (UV-M02^{™}; manufactured by ORC Manufacturing Co., Ltd.) and a filter (UV-35-APR^{™} filter; manufactured by ORC Manufacturing Co., Ltd.), to thereby obtain a cured photosensitive resin layer. The lamp luminance on the photosensitive resin composition surface was measured using a UV meter (UV-M02^{™}; manufactured by ORC Manufacturing Co., Ltd.). The lamp luminance measured using the filter UV-35-APR filter^{™} (manufactured by ORC Manufacturing Co., Ltd.) was 100 mW/cm². The lamp luminance measured using the filter UV-25 filter^{™} (manufactured by ORC Manufacturing Co., Ltd.) was 14 mW/cm². Subsequently, the thickness was cut with a carbide tool to 1.026 mm, to thereby obtain circumference adjustment layer (α). The time required to produce the circumference adjustment layer (α) was less than 20 minutes. Since the photosensitive resin composition (XIV) contained methylstyryl-modified silicone oil, its cutting and polishing properties were dramatically improved.
1 part by weight of thermo-expandable capsules (Matsumoto Microsphere-F-30VS^{™}; manufactured by Matsumoto Yushi-Seiyaku Co., Ltd., optimum foaming temperature: 110 to 120°C, dry weight) was mixed with 99 parts by weight of a liquid photosensitive resin composition (APR-G-42^{™}; manufactured by Asahi Kasei Chemicals Corporation), to thereby obtain a photosensitive resin composition (XV).

The obtained photosensitive resin composition (XV) was applied with a doctor blade to a hollow cylindrical core material mounted on an air cylinder while rotating the air cylinder in a circumferential direction, to thereby form a seamless photosensitive resin composition layer. The thickness of the obtained photosensitive resin composition layer was 50 µm. The obtained photosensitive resin composition layer was then irradiated with light from a chemical lamp at 100 mJ/cm² (energy amount estimated using a UV meter (UV-M02^{™}; manufactured by ORC Manufacturing Co., Ltd.) and a filter (UV-35-APR filter^{™}; manufactured by ORC Manufacturing Co., Ltd.), to thereby obtain a hardened material in a partially cured state (at least an energy of 200 mJ/cm² is required for the hardness to reach a certain value). Subsequently, the partially cured resin layer was heated while being rotated to 150°C using an infrared lamp. The thermo-expandable microcapsules expanded as a result of this heat treatment, whereby an approximately 200 µm-thick circumference adjustment layer was obtained. The resultant product was then irradiated with light from a metal halide lamp at 2,000 mJ/cm² (energy amount estimated using a UV meter (UV-M02^{™}; manufactured by ORC Manufacturing Co., Ltd.) and a filter (UV-35-APR filter^{™}; manufactured by ORC Manufacturing Co., Ltd.)), to perform post-exposure. Subsequently, the thickness of the circumference adjustment layer was shaped by cutting with a carbide tool to 1.026 mm, to thereby obtain a circumference adjustment layer (β). The time required to produce the circumference adjustment layer (β) was less than 20 minutes.
It was confirmed that the circumference adjustment layer having closed cells obtained by thermo-expansion was devitrified and that the thermo-expandable microcapsules had expanded. Observation of the air bubble diameter in the surface vicinity using an optical microscope showed that for the obtained circumference adjustment layer at least 70% of the air bubbles were in the range of 30 to 60 µm, and the average value was 48 µm.
Measurement at 10 places of the diameter of a cylindrical stacked body provided with the produced circumference adjustment layer showed that the degree of precision was within 10 µm.
The shore D hardness of the circumference adjustment layers (α) and (β) was 55 degrees and 58 degrees.

### (Formation of a Cushion Layer)

A 0.55 mm-thick cushion tape provided with an adhesive layer on both sides (1820^{™}; manufactured by 3M Corporation) was adhered to a circumference adjustment layer obtained in the manner described above, taking care not to allow air bubbles to enter, to thereby form a cushion layer (α).
1 part by weight of benzophenone was charged with 99 parts by weight of a liquid photosensitive resin composition (APR-F320^{™}; manufactured by Asahi Kasei Chemicals Corporation), to thereby prepare a liquid photosensitive resin composition (XVI). The obtained liquid photosensitive resin composition (XVI) was applied to a circumference adjustment layer with a doctor blade. The resultant product was photo-cured by irradiating with light from a metal halide lamp, and the thickness was then adjusted by cutting to 0.55 mm, to thereby obtain a cushion layer (β).

### (Production of a Cylindrical Printing Original Plate)

### (Example 1)

A photosensitive resin composition was obtained by using a planetary mixer/deaerator (Mazerustar DD-300^{™}; manufactured by Kurabo Industries Ltd.) to mix together 100 parts by weight of the resin (d1) obtained in the Production Examples, 37 parts by weight of phenoxyethyl methacrylate, 12 parts by weight of butoxydiethylene glycol methacrylate, 7.7 parts by weight of the porous micropowder silica Sylosphere C-1504^{™} manufactured by Fuji Silysia Chemical Ltd. as an inorganic porous material (hereinafter abbreviated as "C-1504"; number average particle diameter: 4.5 µm; specific surface area: 520 m²/g; average pore diameter: 12 nm; pore volume: 1.5 ml/g; ignition loss: 2.5% by weight; and oil absorption value: 290 ml/100 g), 0.9 part by weight of 2,2-dimethoxy-2-phenylacetophenone, 1.5 parts by weight of benzophenone, and 0.5 part by weight of 2,6-di-t-butylacetophenone. The obtained photosensitive resin composition was used in the production of a laser-engravable resin layer (B).
A circumference adjustment layer (α) was stacked on a hollow cylindrical core material (α) produced in the manner described above, and then a cushion layer (α) was further stacked thereabove. Next, a 100 µm-thick PET film with an adhesive layer on one side (rigid body layer (G)) was adhered to the cushion layer (α) so that the adhesive layer was exposed on the surface side, to thereby produce a PET-provided cylindrical laminate body. A photosensitive resin composition for forming a laser-engravable resin layer (B) prepared in the manner described above was applied in a thickness of about 1.5 mm to the obtained cylindrical laminate body with a doctor blade while rotating the air cylinder serving as a cylindrical support in a circumferential direction, to thereby obtain a seamless photosensitive resin composition layer. The obtained photosensitive resin composition layer was then irradiated with ultraviolet rays from a metal halide lamp (M056-L21^{™}; manufactured by Eye Graphics Co., Ltd.) at 4,000 mJ/cm² while rotating the support (energy amount estimated using a UV meter (UV-M02^{™}; manufactured by ORC Manufacturing Co., Ltd.) and a filter (UV-35-APR filter^{™}; manufactured by ORC Manufacturing Co., Ltd.), to thereby obtain a cured photosensitive resin layer. Subsequently, the thickness of the cured photosensitive resin layer was adjusted by cutting with a carbide tool and polishing with an abrasive cloth to produce a laser-engravable hollow cylindrical printing original plate having a 1.14 mm-thick cured photosensitive resin layer. The total processing time required to produce the hollow cylindrical printing original plate was less than 70 minutes.
On the surface of the thus-obtained hollow cylindrical printing original plate, an uneven pattern was formed using a carbon dioxide laser engraver. The debris wiping frequency after laser engraving was a satisfactory 3 times. In addition, the shape of the halftone dot portions was a satisfactory conical shape. "Debris wiping frequency after laser engraving" refers to the number of times that wiping was required to be performed in order to remove the viscous liquid-state debris generated after the engraving. If this number is large, this means that there was a large quantity of liquid-state debris.
The linear thermal expansion coefficient of the PET film used as the rigid body layer (G) was 100 ppm/°C as measured by a thermomechanical measurement (TMA; TMA-50^{™}; manufactured by Shimadzu Corporation).

### (Examples 2-6)

Photosensitive resin compositions were obtained using the resins (d1), (d2) and (d3) obtained in the above-described Production Examples, by adding as shown in Table 1 an organic compound (e), a porous micropowder silica manufactured by Fuji Silysia Chemical Ltd. Sylosphere C-1504^{™} as an inorganic porous material (hereinafter abbreviated as "C-1504"; number average particle diameter: 4.5 µm; specific surface area: 520 m²/g; average pore diameter: 12 nm; pore volume: 1.5 ml/g; ignition loss: 2.5% by weight; and oil absorption value: 290 ml/100 g) and Sylysia 450^{™} (hereinafter abbreviated as "CH 450"; number average particle diameter: 8.0 µm; specific surface area: 300 m²/g; average pore diameter: 17 nm; pore volume: 1.25 ml/g; ignition loss: 5.0% by weight; and oil absorption value: 200 ml/100 g), a photoinitiator and other additives. These photosensitive resin compositions were used in the production of the laser-engravable resin layer (B). Further, a hollow cylindrical core material (α), hollow cylindrical core material (β) hollow cylindrical core material (γ), a circumference adjustment layer (α) or circumference adjustment layer (β), and a cushion layer (α) or cushion layer (β), all obtained in the above-described manner, were combined in each of the examples as shown in Table 2. Next, the photosensitive resin compositions shown in Table 1 were applied in a thickness of about 1.5 mm to the cushion layer with a doctor blade while rotating the air cylinder serving as a cylindrical support in a circumferential direction, to thereby form seamless photosensitive resin composition layers. The obtained photosensitive resin composition layers were then irradiated with ultraviolet rays from a metal halide lamp (M056-L2^{™}; manufactured by Eye Graphics Co., Ltd.) at 4,000 mJ/cm² while rotating the support (energy amount estimated using a UV meter (UV-M02^{™}; manufactured by ORC Manufacturing Co., Ltd.) and a filter (UV-35-APR filter^{™}; manufactured by ORC Manufacturing Co., Ltd.), to thereby obtain cured photosensitive resins. Subsequently, the thickness of the obtained cured photosensitive resins was adjusted by cutting with a carbide tool and polishing with an abrasive cloth to produce a laser-engravable hollow cylindrical printing original plates having a 1.14 mm-thick cured photosensitive resin layer.
On the surface of the thus-obtained hollow cylindrical printing original plate, an uneven pattern was formed using a carbon dioxide laser engraver. The evaluated results are shown in Table 2.
"Debris wiping frequency after engraving" in Table 2 refers to the number of times that wiping was required to be performed in order to remove the viscous liquid-state debris generated after the engraving. If this number is large, this means that there was a large quantity of liquid-state debris.

### (Example 7)

A highly viscous liquid photosensitive resin composition was obtained by using a kneader to mix 60 parts by weight of a styrene-butadiene copolymer (Tufprene A^{™}; manufactured by Asahi Kasei Chemicals Corporation; number average molecular weight: 73,000), 29 parts by weight of a liquid polybutadiene (B-2000^{™}; manufactured by Nippon Petrochemicals Company Limited; number average molecular weight: 2,000), 7 parts by weight of 1,9-nonanediol diacrylate (number average molecular weight: 268), 2 parts by weight of 2,2-dimethoxy-phenylacetophenone and 1 part by weight of 2,6-di-t-butyl-p-cresol, and then mixing into the resultant mixture 20 parts by weight of toluene per 10 parts of mixture.
In the same manner as in Example 1, a PET film was adhered to a cushion layer (α), and on top of this the obtained liquid photosensitive resin composition was applied using a doctor blade. While slowly rotating the cylindrical support, drying was carried out by causing the solvent toluene to scatter, whereby a 1.14 mm-thick seamless solid-state photosensitive resin layer was obtained. Next, a film-like exposure mask having a mold release layer on its surface was wound around the obtained solid photosensitive resin layer. Irradiation with light from a chemical lamp was performed through the exposure mask to form a latent image. The film-like exposure mask was peeled off, and developing was carried out with a hydrocarbon solvent to form an uneven pattern on the surface, whereby a cylindrical printing plate was produced. A satisfactory conical pattern was formed at the fine halftone dot pattern portion.

### (Example 8)

The above-described liquid photosensitive resin composition (XI) was applied to a 50 µm thickness to one surface of a 50 mm-wide 25 µm-thick PET film. The resulting product was triply wound in a spiral shape around an air cylinder, which had an outer dimension of 213.384 mm and whose surface had been mold-release-treated, from the surface coated with the photosensitive resin composition such that the PET film ends slightly overlapped. In this state the photosensitive resin composition was photo-cured by irradiating with light from a metal halide lamp (M056-L21^{™}; manufactured by Eye Graphics Co., Ltd.) in a nitrogen atmosphere at 2,000 mJ/cm² (value obtained by integrating with time the luminance measured using a UV meter (UV-M02^{™}; manufactured by ORC Manufacturing Co., Ltd.) and a filter (UV-35-APR filter^{™}; manufactured by ORC Manufacturing Co., Ltd.), to thereby form a hollow cylindrical core material. The elevation difference in the thickness of the obtained hollow cylindrical core material was 80 µm. The inner-side surface of the obtained hollow cylindrical core material was a smooth surface as if it had copied the smoothness of the air cylinder surface. The linear thermal expansion coefficient of the PET film used to produce the hollow cylindrical core material was 90 ppm/°C. Further, light transmittance in the 360 nm to 370 nm wavelength range was 90%.
A photosensitive resin composition (APR-G-42^{™}; manufactured by Asahi Kasei Chemicals Corporation) was applied to the obtained hollow cylindrical core material with a doctor blade in a thickness of about 1.1 mm, and then photo-cured by irradiating with light from a metal halide lamp (M056-L21^{™}; manufactured by Eye Graphics Co., Ltd.) in a nitrogen atmosphere at 4,000 mJ/cm² (value obtained by integrating with time the luminance measured using a UV meter (UV-M02^{™}; manufactured by ORC Manufacturing Co., Ltd.) and a filter (UV-35-APR filter^{™}; manufactured by ORC Manufacturing Co., Ltd.), whereby a cured photosensitive resin layer was obtained. The lamp luminance on the photosensitive resin composition layer was measured using a UV meter (UV-M02^{™}; manufactured by ORC Manufacturing Co., Ltd.). The lamp luminance measured using the filter UV-35-APR filter^{™} (manufactured by ORC Manufacturing Co., Ltd.) was 100 mW/cm². The lamp luminance measured using the filter UV-25 filter^{™} (manufactured by ORC Manufacturing Co., Ltd.) was 14 mW/cm². Subsequently, the thickness was adjusted to 1.026 mm by cutting with a carbide tool, to thereby obtain a circumference adjustment layer.
A cushion tape provided with an adhesive layer on both sides (1820^{™}; manufactured by 3M Corporation) was adhered once around the obtained circumference adjustment layer taking care not to allow air bubbles to enter. Onto this was applied the photosensitive resin composition for forming the resin layer (B) used in Example 1, and a laser-engravable cured photosensitive resin was obtained by photo-curing. Further, a laser-engravable hollow cylindrical printing original plate having a surface elevation difference of less than 20 µm was produced by cutting and polishing the film to adjust its thickness.
An uneven pattern was formed on the surface of the produced hollow cylindrical printing original plate using a carbon dioxide laser engraving apparatus. The shape of the formed halftone dot pattern was a satisfactory conical shape.
A printing test performed using a flexographic press on the hollow cylindrical printing original plate which had a pattern formed on its surface showed that a printed product that had a satisfactory halftone dot pattern could be obtained. The print test was carried out using the combination of UV ink and coated paper at a print rate of 200 m/min. The UV ink transferred to the coated paper was cured by irradiating with light from an ultraviolet ray lamp, thereby being fixed on the coated paper.

### (Example 9)

A liquid photosensitive resin composition (APR-G-42^{™}; manufactured by Asahi Kasei Chemicals Corporation) was applied in a thickness of about 0.5 mm to an air cylinder having an outer dimension of 213.384 mm and whose surface had been mold-release-treated, and a 50 mm-wide 300 µm-thick glass cloth was triply wound thereon in a spiral shape. The above-described liquid photosensitive resin composition was also applied to the glass cloth surface and into the glass cloth mesh, so that at a depth of 0.5 mm from the surface there was no glass cloth present. In addition, while rotating the air cylinder in a circumferential direction, irradiation with light from a metal halide lamp (M056-L21^{™}; manufactured by Eye Graphics Co., Ltd.) was performed in air at 4,000 mJ/cm² (value obtained by integrating with time the luminance measured using a UV meter (UV-M02^{™}; manufactured by ORC Manufacturing Co., Ltd.) and a filter (UV-35-APR filter^{™}; manufactured by ORC Manufacturing Co., Ltd.), whereby a cured photosensitive resin layer (1) was obtained. The lamp luminance on the cured photosensitive resin composition layer surface was measured using a UV meter (UV-M02^{™}; manufactured by ORC Manufacturing Co., Ltd.). The lamp luminance measured using the filter UV-35-APR filter^{™} (manufactured by ORC Manufacturing Co., Ltd.) was 100 mW/cm². The lamp luminance measured using the filter UV-25 filter^{™} (manufactured by ORC Manufacturing Co., Ltd.) was 14 mW/cm². Tack remained on the surface, so that it took time to grind the surface. Further, polishing debris occasionally became entangled in the polishing wheel during the polishing.
A laser-engravable resin layer (B) was formed on the obtained hollow cylindrical core material in the same manner as in Example 1 and using the same photosensitive resin as in Example 1.

### (Comparative Example 1)

An attempt was made to produce a hollow cylindrical core material in the same manner as in Example 1, except for using a thermosetting two-component epoxy resin and heating at 50°C in place of photo-curing a liquid photosensitive resin composition. The epoxy resin took 1 day to completely cure.
Further, if heating was conducted at above 50°C, the dimensions were not uniform, and air bubbles in various shapes and sizes were generated in a large quantity. In addition, the viscosity of the used epoxy resin at 20°C was less than 10 Pa·s, whereby it was difficult to maintain a cylindrical shape in the step of applying the epoxy resin to the cylindrical body support. The hollow cylindrical core material into which a large quantity of air bubbles had entered had a low strength, and would partially break just by applying strength with a hand.

### (Comparative Example 2)

A highly viscous liquid resin composition was obtained by using a kneader to mix 80 parts by weight of a styrene-butadiene copolymer (Tufprene A^{™}; manufactured by Asahi Kasei Chemicals Corporation; number average molecular weight: 73,000), and 20 parts by weight of a liquid polybutadiene (B-2000^{™}; manufactured by Nippon Petrochemicals Company Limited; number average molecular weight: 2,000), and then mixing into the resultant mixture 20 parts by weight of toluene per 10 parts of mixture.
The obtained liquid resin composition was applied in a 50 µm thickness to one surface of a 50 mm-wide 25 µm-thick polysulfone film. The resultant product was triply wound in a spiral shape while heating with an infrared heater around an air cylinder having an outer dimension of 213.384 mm and whose surface had been mold-release-treated from the surface coated with the resin composition such that the polysulfone film ends slightly overlapped. Once cooled, a hollow cylindrical core material was obtained.
A photosensitive resin composition which was solid at 20°C was obtained by using a kneader to mix 60 parts by weight of a styrene-butadiene copolymer (Tufprene A^{™}; manufactured by Asahi Kasei Chemicals Corporation; number average molecular weight: 73,000), 29 parts by weight of a liquid polybutadiene (B-2000^{™}; manufactured by Nippon Petrochemicals Company Limited; number average molecular weight: 2,000), 7 parts by weight of 1,9-nonanediol diacrylate (molecular weight: 268), 2 parts by weight of 2,2-dimethoxy-phenylacetophenone and 1 part by weight of 2,6-di-t-butyl-p-cresol.
The above-described solid photosensitive resin composition was applied in a state heated to 140°C to the obtained hollow cylindrical core material using an extruder. Once cooled, it was visually observed that the hollow cylindrical core material had been substantially deformed as a result of the formation of air bubbles and the like.

### (Comparative Example 3)

A liquid unsaturated polyester resin containing a volatile solvent was applied in a thickness of about 0.5 mm to an air cylinder having an outer dimension of 213.384 mm and whose surface had been mold-release-treated, and a 50 mm-wide and 300 µm-thick glass cloth was wound thereon in a spiral shape five times. The above-described liquid unsaturated polyester resin was also applied to the glass cloth surface and into the glass cloth mesh. A mold-release-treated 25 µm-thick PET film was wound around the thus-obtained surface, and the resultant object was cured for 1 day in an oven heated to 70°C. Once cooled, the surface PET film was peeled off to thereby obtain a hollow cylindrical core material. The surface elevation difference was large at more than 500 µm, so that the surface was ground to make it smoother. The time taken for this process was 60 minutes. Some parts of the glass cloth were exposed, whereby dust flew around making it difficult to carry out the polishing.
An adhesive was thinly applied to the hollow cylindrical core material whose surface had been ground. To adjust the circumference, a 50 mm-wide 200 µm-thick hard urethane rubber sheet in which a crosslinking agent had been mixed was wound thereon while being heated and applying with pressure. Subsequently, a mold-release-treated PET film was wound around the obtained rubber surface, and the resultant object was heated in an oven left for 1 day. Once cooled, the rubber surface was smoothened by polishing. The time taken for this process was 40 minutes. The resultant object was then left for several days at room temperature, whereupon since the film thickness of the rubber layer had shrunk in places about 30 µm, the surface was again subjected to polishing.
A laser-engravable resin layer (B) was formed on the surface of the obtained rubber layer in the same manner as in Example 1 and using the same photosensitive resin composition as in Example 1.

**[Table 1]**

| | Resin (d) | | Organic compound (e) | | Inorganic porous material (f) | | Photoinitiator | | Other additives | |
|---|---|---|---|---|---|---|---|---|---|---|
| | Type | Blend amount | Type | Blend amount | Type | Blend amount | Type | Blend amount | Type | Blend amount |
| Example 2 | (d2) | 100 | PEMA | 37 | C-1504 | 7.7 | DMPAP | 0.9 | BHT | 0.5 |
| | | | BDEGMA | 12 | | | BP | 1.5 | | |
| Example 3 | (d3) | 100 | as above | | as above | | as above | | as above | |
| Example 4 | (d1) | 100 | LMA | 6 | as above | | as above | | as above | |
| | | | PPMA | 15 | | | | | | |
| | | | DEEHEA | 25 | | | | | | |
| | | | TEGDMA | 2 | | | | | | |
| | | | TMPTMA | 2 | | | | | | |
| Example 5 | (d1) | 100 | BZMA | 25 | as above | | as above | | as above | |
| | | | CHMA | 19 | | | | | | |
| | | | BDEGMA | 6 | | | | | | |
| Example 6 | (d1) | 100 | as above | | CH-450 | 7.7 | as above | | as above | |

| | | | | | | | | | | |
|---|---|---|---|---|---|---|---|---|---|---|
| Units for the blend amount in the Table: parts by weight (Explanation of abbreviations) LMA : lauryl methacrylate (Mn254) PPMA : polypropylene glycol monomethacrylate (Mn400) DEEHEA : diethylene glycol-2-ethylhexylmethacrylate (Mn286) TEGDMA : tetraethylene glycol dimethacrylate (Mn330) TMPTMA : trimethylolpropane trimethacrylate (Mn339) BZMA : benzyl methacrylate (Mn176) CHMA : cyclohexyl methacrylate (Mn167) BDEGMA : butoxydiethylene glycol methacrylate (Mn230) PEMA : phenoxyethyl methacrylate (Mn206) DMPAP : 2,2-dimethoxy-2-phenylacetophonone BP : benzophenone BHT : 2,6-di-t-butylacetophenone | | | | | | | | | | |

**[Table 2]**

| | Hollow cylindrical core material | Circumference adjustment layer | Cushion layer | Debris wiping frequency after laser engraving (BEMCOT provided with ethanol) | Shape of halftone dot portions |
|---|---|---|---|---|---|
| Example 2 | α | α | α | ≦3 | satisfactory conical shape |
| Example 3 | α | α | α | ≦3 | satisfactory conical shape |
| Example 4 | β | α | β | ≦3 | satisfactory conical shape |
| Example 5 | β | β | β | ≦3 | satisfactory conical shape |
| Example 6 | γ | β | β | ≦3 | satisfactory conical shape |

### INDUSTRIAL APPLICABILITY

The present invention is suitable for a hollow cylindrical printing element, and production method thereof, used in the production of a flexographic printing plate from laser engraving or a relief image; the formation of a pattern used in surface treatments such as embossing; the formation of printing relief images such as tiles or the like; pattern printing of conductors, semiconductors and insulators used in electronic circuit formation; an antireflection film for optical parts; the pattern formation of a functional material such as color filters and (near) infrared cut filters; as well as for the coating and pattern formation of oriented films, underlayers, light-emitting layers, electron transporting layers and sealant layers in the production of display elements such as liquid crystal displays and organic electroluminescent displays.

## Claims

1. A cylindrical printing element comprising a hollow cylindrical core material (A) which comprises a cured photosensitive resin layer (1) having a thickness of not less than 0.05 mm and not more than 50 mm, said cured photosensitive resin layer (1) having a fiber-like, cloth-like, or film-like reinforcement material, said cured photosensitive resin layer (1) comprising a photoinitiator or a degradation product of said photoinitiator, wherein said photoinitiator comprises a hydrogen abstracting photoinitiator and a degradable photoinitiator, or comprises a compound containing in the same molecule a moiety which acts as a hydrogen abstracting photoinitiator and a moiety which acts as a degradable photoinitiator, and said cured photosensitive resin layer (1) having a shore D hardness of not less than 30 degrees and not more than 100 degrees; and
a resin layer (B) or a resin layer (C) having a thickness of not less than 0.1 mm and not more than 100 mm stacked on said hollow cylindrical core material (A), said resin layer (B) capable of forming a pattern on a surface thereof or said resin layer (C) having a pattern formed on a surface thereof.

2. The cylindrical printing element according to claim 1, wherein the resin layer (B) is a photosensitive resin composition layer capable of forming a pattern by a photoengraving technique or is a laser-engravable cured photosensitive resin layer (3).

3. The hollow cylindrical printing element according to claim 1, further comprising at least one resin layer (D) stacked on an inner surface of the hollow cylindrical core material (A) to provide a cylindrical structure, said resin layer (D) having a thickness of not less than 0.01 mm and not more than 0.5 mm.

4. The hollow cylindrical printing element according to any one of claims 1 to 3, further comprising a cushion layer (E) stacked between the hollow cylindrical core material (A) and the resin layer (B) or resin layer (C) to provide a cylindrical structure, said cushion layer (E) having a thickness of not less than 0.05 mm and not more than 50 mm.

5. The hollow cylindrical printing element according to claim 4, further comprising a circumference adjustment layer (F) stacked between the hollow cylindrical core material (A) and the cushion layer (E) to provide a cylindrical structure, said circumference adjustment layer (F) having a thickness of not less than 0.1 mm and not more than 100 mm.

6. The hollow cylindrical printing element according to claim 4, further comprising a rigid body layer (G) stacked between the resin layer (B) or resin layer (C) and the cushion layer (E) to provide a hollow cylindrical structure, said rigid body layer (G) having a thickness of not less than 0.01 mm and not more than 0.5 mm.

7. The hollow cylindrical printing element according to any one of claims 1 to 6, wherein a cured photosensitive resin constituting at least the hollow cylindrical core material (A) among the hollow cylindrical core material (A), circumference adjustment layer (F), cushion layer (E), rigid body layer (G), resin layer (B) and resin layer (C) is formed by photo-curing a photosensitive resin composition which is in a liquid state at 20°C.

8. The hollow cylindrical printing element according to claim 2, wherein the resin layer (B) made of the laser-engravable cured photosensitive resin layer (3) comprises a compound having at least one bond selected from the group consisting of a carbonate bond, a urethane bond and an ester bond, and an inorganic porous material.

9. The hollow cylindrical printing element according to claim 1, wherein the hollow cylindrical core material (A) comprises uneven portions on a surface, the uneven portions having a difference in elevation of not less than 20 µm and not more than 500 µm.

10. A hollow cylindrical core material for forming a hollow cylindrical printing element, comprising a cured photosensitive resin layer (1) having a thickness of not less than 0.05 mm and not more than 50 mm, said cured photosensitive resin layer (1) comprising a fiber-like, cloth-like or film-like reinforcement material, said cured photosensitive resin layer (1) comprising a photoinitiator or a degradation product of said photoinitiator, wherein said photoinitiator comprises a hydrogen abstracting photoinitiator and a degradable photoinitiator, or comprises a compound containing in the same molecule a moiety which acts as a hydrogen abstracting photoinitiator and a moiety which acts as a degradable photoinitiator, and said cured photosensitive resin layer (1) having a shore D hardness of not less than 30 degrees and not more than 100 degrees.

11. A method for producing a hollow cylindrical printing base material comprising the steps of: applying a photosensitive resin composition which comprises a photoinitiator to a cylindrical support; photo-curing by irradiating with beams containing light which is 200nm to 450nm; adjusting the film thickness of the obtained cured photosensitive resin layer; and stacking a patternable resin layer (B) or surface-patterned resin layer (C) on a hollow cylindrical core material (A) formed from the above-described steps, wherein said photoinitiator comprises a hydrogen abstracting photoinitiator and a degradable photoinitiator, or a compound having in the same molecule a moiety which acts as a hydrogen abstracting photoinitiator and a moiety which acts as a degradable photoinitiator.

12. The method according to claim 11 further comprising the step of: providing a fiber-like, cloth-like or film-like reinforcement material on a cylindrical support surface before the step of applying said photosensitive resin composition.

13. The method according to claim 11 wherein the step of applying a photosensitive resin composition is the step of winding around a cylindrical support surface a sheet-like material obtained by incorporating a liquid photosensitive resin composition or a semi-cured product of a liquid photosensitive resin composition into a fiber-like, cloth-like or film-like reinforcement material.

14. The method according to claim 12 or 13, wherein a method for stacking the resin layer (B) comprises a step of applying a photosensitive resin composition, or a step of applying and then photo-curing a photosensitive resin composition, or a step of adhering a photosensitive resin composition layer formed in a sheet shape via an adhesive or a pressure-sensitive adhesive; and wherein a method for stacking the resin layer (C) comprises the step of adhering a patterned sheet-like material via an adhesive or a pressure-sensitive adhesive.

15. The method according to claim 12 or 13, further comprising a step of forming at least one resin layer (D) onto the cylindrical support prior to the step of forming the hollow cylindrical core material (A), wherein said step of forming the resin layer (D) comprises a step of winding a resin film around the cylindrical support so that both edge portions of said resin film do not overlap, and such that a seam formed where the two edge portions meet does not exceed 2 mm, or a step of covering with a seamless resin tube formed in a cylindrical shape, or a step of applying a liquid photosensitive resin composition to a cylindrical support and photo-curing it by irradiating it with light.

16. The method according to any one of claims 12 to 15, comprising a step of stacking a circumference adjustment layer (F) on the hollow cylindrical core material (A) prior to the step of stacking the resin layer (B) or resin layer (C), wherein said step of stacking a circumference adjustment layer (F) comprises a step of applying a liquid photosensitive resin to the hollow cylindrical core material (A) and photo-curing it by irradiating it with light.

17. The method according to claim 16, comprising a step of stacking a cushion layer (E) on the hollow cylindrical core material (A) or circumference adjustment layer (F) prior to the step of stacking the resin layer (B) or resin layer (C), wherein said step of stacking a cushion layer (E) comprises a step of applying a liquid photosensitive resin to the hollow cylindrical core material (A) or circumference adjustment layer (F) and photo-curing it by irradiating it with light, or a step of adhering a cushion tape via an adhesive layer or a pressure-sensitive adhesive layer.

18. The method according to claim 17, comprising a step of stacking a rigid body layer (G) on the cushion layer (E) prior to the step of stacking the resin layer (B) or resin layer (C), wherein said step of stacking a rigid body layer (G) comprises a step of adhering a resin film to the cushion layer (E) via an adhesive layer or a pressure-sensitive adhesive layer, or a step of applying a liquid photosensitive resin composition and photo-curing it by irradiating it with light.

19. The method according to any one of claims 12 to 18, further comprising, after a step of adjusting (or forming) a film thickness of the cured photosensitive resin layer (1), at least one step selected from the group consisting of a step of cutting a surface, a step of grinding a surface, and a step of polishing a surface.

20. The method according to any one of claims 12 to 19, wherein in the step of forming the cured photosensitive resin layer (1) the photosensitive resin composition layer is irradiated with light in air.

21. The method according to any one of claims 12 to 20, comprising, after formation of the hollow cylindrical printing element, a step of removing said hollow cylindrical printing element from the cylindrical support.

## Patentansprüche

1. Zylindrisches Druckelement, mit einem hohlzylindrischen Kernmaterial (A), welches eine gehärtete fotosensitive Harzschicht (1) mit einer Dicke von nicht weniger als 0,05 mm und nicht mehr als 50 mm aumfasst, wobei die gehärtete fotosensitive Harzschicht (1) ein faserartiges, gewebeartiges oder film- bzw. folienartiges Verstärkungsmaterial aufweist, wobei die gehärtete fotosensitive Harzschicht (1) einen Fotoinitiator oder ein Abbauprodukt des Fotoinitiators aufweist, worin der Fotoinitiator einen Wasserstoff-abstrahierenden Fotoinitiator und einen abbaubaren Fotoinitiator beinhaltet, oder eine Verbindung aufweist, welche im gleichen Molekül einen Teil enthält, der als Wasserstoff-abstrahierender Fotoinitiator wirkt, und einen Teil, der als abbaubarer Fotoinitiator wirkt, und wobei die gehärtete fotosensitive Harzschicht (1) eine Shore D-Härte von nicht weniger als 30 Grad und nicht mehr als 100 Grad aufweist; und
einer Harzschicht (B) oder einer Harzschicht (C) mit einer Dicke von nicht weniger als 0,1 mm und nicht mehr als 100 mm, die auf das hohlzylindrische Kernmaterial (A) geschichtet ist, wobei die Harzschicht (B) befähigt ist, ein Muster auf ihrer Oberfläche auszubilden, oder die Harzschicht (C) ein auf einer Oberfläche dieser gebildetes Muster aufweist.

2. Zylindrisches Druckelement nach Anspruch 1, worin die Harzschicht (B) eine fotosensitive Harzzusammensetzungsschicht ist, die befähigt ist, mittels eines Fotogravierverfahrens ein Muster auszubilden, oder eine lasergravierbare, gehärtete fotosensitive Harzschicht (3) ist.

3. Hohlzylindrisches Druckelement nach Anspruch 1, welches weiterhin mindestens eine Harzschicht (D) aufweist, die auf eine innere Oberfläche des hohlen zylindrischen Kernmaterials (A) geschichtet ist, so dass eine zylindrische Struktur vorgesehen wird, wobei die Harzschicht (D) eine Dicke von nicht weniger als 0,01 mm und nicht mehr als 0,5 mm aufweist.

4. Hohlzylindrisches Druckelement nach einem der Ansprüche 1 bis 3, welches weiterhin eine Dämpfungsschicht (E) aufweist, die zwischen das hohlzylindrische Kernmaterial (A) und die Harzschicht (B) oder die Harzschicht (C) geschichtet ist, so dass eine zylindrische Struktur vorgesehen wird, wobei die Dämpfungsschicht (E) eine Dicke von nicht weniger als 0,05 mm und nicht mehr als 50 mm aufweist.

5. Hohlzylindrisches Druckelement nach Anspruch 4, welches weiterhin eine Umfangseinstellschicht (F) aufweist, die zwischen das hohlzylindrische Kernmaterial (A) und die Dämpfungsschicht (E) geschichtet ist, so dass eine zylindrische Struktur vorgesehen wird, wobei die Umfangseinstellschicht (F) eine Dicke von nicht weniger als 0,1 mm und nicht mehr als 100 mm aufweist.

6. Hohlzylindrisches Druckelement nach Anspruch 4, welches weiterhin eine Schicht eines steifen Körpers (G) aufweist, die zwischen die Harzschicht (B) oder die Harzschicht (C) und die Dämpfungsschicht (E) geschichtet ist, so dass eine hohlzylindrische Struktur vorgesehen wird, wobei die Schicht eines steifen Körpers (G) eine Dicke von nicht weniger als 0,01 mm und nicht mehr als 0,5 mm aufweist.

7. Hohlzylindrisches Druckelement nach einem der Ansprüche 1 bis 6, worin ein gehärtetes fotosensitives Harz, welches unter dem hohlzylindrischen Kernmaterial (A), der Umfangseinstellschicht (F), der Dämpfungsschicht (E), der Schicht eines festen Körpers (G), der Harzschicht (B) und der Harzschicht (C) zumindest das hohlzylindrische Kernmaterial (A) bildet, durch Fotohärten einer fotosensitiven Harzzusammensetzung, die bei 20 °C in einem flüssigen Zustand ist, gebildet wird.

8. Hohlzylindrisches Druckelement nach Anspruch 2, worin die aus der lasergravierbaren gehärteten fotosensitiven Harzschicht (3) gebildete Harzschicht (B) eine Verbindung enthält, die mindestens eine Bindung aufweist, ausgewählt aus der Gruppe, bestehend aus einer Carbonatbindung, einer Urethanbindung und einer Esterbindung, sowie ein anorganisches poröses Material.

9. Hohlzylindrisches Druckelement nach Anspruch 1, worin das hohlzylindrische Kernmaterial (A) unebene Bereiche auf einer Oberfläche aufweist, wobei die unebenen Bereiche eine Höhendifferenz von nicht weniger als 20 µm und nicht mehr als 500 µm aufweisen.

10. Hohlzylindrisches Kernmaterial für die Bildung eines hohlzylindrischen Druckelements, umfassend eine gehärtete fotosensitive Harzschicht (1) mit einer Dicke von nicht weniger als 0,05 mm und nicht mehr als 50 mm, wobei die gehärtete fotosensitive Harzschicht (1) ein faserartiges, gewebeartiges oder film- bzw. folienartiges Verstärkungsmaterial aufweist, wobei die gehärtete fotosensitive Harzschicht (1) einen Fotoinitiator oder ein Abbauprodukt des Fotoinitiators enthält, worin der Fotoinitiator einen Wasserstoff-abstrahierenden Fotoinitiator und einen abbaubaren Fotoinitiator beinhaltet, oder eine Verbindung beinhaltet, die im gleichen Molekül einen Teil aufweist, der als Wasserstoff-abstrahierender Fotoinitiator wirkt, und einen Teil, der als abbaubarer Fotoinitiator wirkt, und wobei die gehärtete fotosensitive Harzschicht (1) eine Shore D-Härte von nicht weniger als 30 Grad und nicht mehr als 100 Grad aufweist.

11. Verfahren zur Herstellung eines hohlzylindrischen Druckbasismaterials, umfassend die Schritte:
Aufbringen einer fotosensitiven Harzzusammensetzung, die einen Fotoinitiator enthält, auf einen zylindrischen Träger; Fotohärten durch Bestrahlen mit Strahlen, die Licht von 200 nm bis 450 nm enthalten;
Einstellen der Filmdicke der erhaltenen, gehärteten fotosensitiven Harzschicht; und
Schichten einer mit einem Muster versehbaren Harzschicht (B) oder einer Harzschicht mit Oberflächenmuster (C) auf ein hohlzylindrisches Kernmaterial (A), welches durch die oben beschriebenen Schritte gebildet wurde, worin der Fotoinitiator einen Wasserstoff-abstrahierenden Fotoinitiator und einen abbaubaren Fotoinitiator beinhaltet, oder eine Verbindung, die im gleichen Molekül einen Teil aufweist, der als Wasserstoff-abstrahierender Fotoinitiator wirkt, und einen Teil, der als abbaubarer Fotoinitiator wirkt.

12. Verfahren nach Anspruch 11, weiterhin umfassend den Schritt: Vorsehen eines faserartigen, gewebeartigen oder film- bzw. folienartigen Verstärkungsmaterial auf einer zylindrischen Trägeroberfläche vor dem Schritt des Aufbringens der fotosensitiven Harzzusammensetzung.

13. Verfahren nach Anspruch 11, worin der Schritt des Aufbringens einer fotosensitiven Harzzusammensetzung ein Schritt des Wickkelns eines schichtartigen Materials, erhalten durch Einbeziehen einer flüssigen fotosensitiven Harzzusammensetzung oder eines halbgehärteten Produkts einer flüssigen fotosensitiven Harzzusammensetzung in ein faserartiges, gewebeartiges oder film- bzw. folienartiges Verstärkungsmaterial, um eine zylindrische Trägeroberfläche ist.

14. Verfahren nach Anspruch 12 oder 13, worin ein Verfahren zum Schichten der Harzschicht (B) einen Schritt des Aufbringens einer fotosensitiven Harzzusammensetzung oder einen Schritt des Aufbringens und anschließend Fotohärtens einer fotosensitiven Harzzusammensetzung oder einen Schritt des Anhaftens einer fotosensitiven Harzzusammensetzungsschicht, die in Schichtform ausgebildet ist, mittels eines Haftstoffs oder eines druckempfindlichen Haftstoffs beinhaltet; und worin ein Verfahren zum Schichten der Harzschicht (C) den Schritt des Haftens eines gemusterten schichtartigen Materials mittels eines Haftstoffs oder eines druckempfindlichen Haftstoffs beinhaltet.

15. Verfahren nach Anspruch 12 oder 13, weiterhin umfassend einen Schritt des Bildens mindestens einer Harzschicht (D) auf dem zylindrischen Träger vor dem Schritt des Bildens des hohlzylindrischen Kernmaterials (A), worin der Schritt des Bildens der Harzschicht (D) einen Schritt des Wickelns eines Harzfilms bzw. einer Harzfolie um den zylindrischen Träger beinhaltet, derart, dass beide Kantenbereiche des Harzfilms nicht überlappen, und derart, dass ein Spalt, der dort gebildet wird, wo die zwei Kantenbereiche aufeinander treffen, 2 mm nicht überschreitet, oder einen Schritt des Beschichtens mit einem naht- bzw. spaltfreien Harzrohr, das zylindrisch gebildet ist, oder einen Schritt des Aufbringens einer flüssigen fotosensitiven Harzzusammensetzung auf einen zylindrischen Träger und Fotohärten dieser durch Bestrahlung mit Licht.

16. Verfahren nach einem der Ansprüche 12 bis 15, umfassend einen Schritt des Schichtens einer Umfangseinstellschicht (F) auf das hohlzylindrische Kernmaterial (A) vor dem Schritt des Schichtens der Harzschicht (B) oder der Harzschicht (C), worin der Schritt des Schichtens einer Umfangseinstellschicht (F) einen Schritt des Aufbringens eines flüssigen fotosensitiven Harzes auf das hohlzylindrische Kernmaterial (A) und ein Fotohärten hiervon durch Bestrahlung mit Licht beinhaltet.

17. Verfahren nach Anspruch 16, umfassend einen Schritt des Schichtens einer Dämpfungsschicht (E) auf das hohlzylindrische Kernmaterial (A) oder die Umfangseinstellschicht (F) vor dem Schritt des Schichtens der Harzschicht (B) oder der Harzschicht (C), worin der Schritt des Schichtens der Dämpfungsschicht (E) einen Schritt des Aufbringens eines flüssigen fotosensitiven Harzes auf das hohlzylindrische Kernmaterial (A) oder die Umfangseinstellschicht (F) und das Fotohärten hiervon durch Bestrahlen mit Licht beinhaltet, oder einen Schritt des Anhaftens eines Dämpfungsbands mittels einer Haftschicht oder einer druckempfindlichen Haftschicht.

18. Verfahren nach Anspruch 17, umfassend einen Schritt des Schichtens einer Schicht eines steifen Körpers (G) auf die Dämpfungsschicht (E) vor dem Schritt des Schichtens der Harzschicht (B) oder der Harzschicht (C), worin der Schritt des Schichtens einer Schicht eines steifen Körpers (G) einen Schritt des Anhaftens eines Harzfilms bzw. einer Harzfolie an die Dämpfungsschicht (E) mittels einer Haftschicht oder einer druckempfindlichen Haftschicht beinhaltet, oder einen Schritt des Aufbringen einer flüssigen fotosensitiven Harzzusammensetzung und Fotohärten dieser durch Bestrahlung mit Licht.

19. Verfahren nach einem der Ansprüche 12 bis 18, welches weiterhin nach dem Schritt des Einstellens (oder Bildens) einer Filmdicke der gehärteten fotosensitiven Harzschicht (1) mindestens einen Schritt umfasst, ausgewählt aus der Gruppe, bestehend aus einem Schritt des (Ein)Schneidens einer Oberfläche, einem Schritt des Schleifens einer Oberfläche und einem Schritt des Polierens einer Oberfläche.

20. Verfahren nach einem der Ansprüche 12 bis 19, worin bei dem Schritt des Bildens der gehärteten fotosensitiven Harzschicht (1) die fotosensitive Harzzusammensetzungsschicht an der Luft mit Licht bestrahlt wird.

21. Verfahren nach einem der Ansprüche 12 bis 20, welches nach der Ausbildung des hohlzylindrischen Druckelements einen Schritt des Entfernens des hohlzylindrischen Druckelements von dem zylindrischen Träger umfasst.

## Revendications

1. Elément d'impression cylindrique comprenant un matériau de noyau cylindrique creux (A) qui comprend une couche de résine photosensible (1) durcie ayant une épaisseur non inférieure à 0,05 mm et non supérieure à 50 mm, ladite couche de résine photosensible (1) durcie ayant un matériau de renforcement de type fibre, de type tissu ou de type film, ladite couche de résine photosensible (1) durcie comprenant un photo-initiateur ou un produit de dégradation dudit photo-initiateur, dans lequel ledit photo-initiateur comprend un photo-initiateur à extraction d'hydrogène et un photo-initiateur dégradable, ou comprend un composé contenant, dans la même molécule, un groupe caractéristique qui sert de photo-initiateur à extraction d'hydrogène et un groupe caractéristique qui sert de photo-initiateur dégradable et ladite couche de résine photosensible (1) durcie ayant une dureté Shore D non inférieure à 30 degrés et non supérieure à 100 degrés ; et
une couche de résine (B) ou une couche de résine (C) ayant une épaisseur non inférieure à 0,1 mm et non supérieure à 100 mm empilée sur ledit matériau de noyau cylindrique creux (A), ladite couche de résine (B) pouvant former un modèle sur sa surface ou ladite couche de résine (C) ayant un modèle formé sur sa surface.

2. Elément d'impression cylindrique selon la revendication 1, dans lequel la couche de résine (B) est une couche de composition de résine photosensible pouvant former un modèle par une technique de photogravure ou bien est une couche de résine photosensible (3) durcie pouvant être gravée au laser.

3. Elément d'impression cylindrique creux selon la revendication 1, comprenant en outre au moins une couche de résine (D) empilée sur une surface interne du matériau de noyau cylindrique creux (A) afin de proposer une structure cylindrique, ladite couche de résine (D) ayant une épaisseur non inférieure à 0,01 mm et non supérieure à 0,5 mm.

4. Elément d'impression cylindrique creux selon l'une quelconque des revendications 1 à 3, comprenant en outre une couche d'amortissement (E) empilée entre le matériau de noyau cylindrique creux (A) et la couche de résine (B) ou la couche de résine (C) afin de proposer une structure cylindrique, ladite couche d'amortissement (E) ayant une épaisseur non inférieure à 0,05 mm et non supérieure à 50 mm.

5. Elément d'impression cylindrique creux selon la revendication 4, comprenant en outre une couche d'ajustement de circonférence (F) empilée entre le matériau de noyau cylindrique creux (A) et la couche d'amortissement (E) pour proposer une structure cylindrique, ladite couche d'ajustement de circonférence (F) ayant une épaisseur non inférieure à 0,1 mm et non supérieure à 100 mm.

6. Elément d'impression cylindrique creux selon la revendication 4, comprenant en outre une couche de corps rigide (G) empilée entre la couche de résine (B) ou la couche de résine (C) et la couche d'amortissement (E) afin de proposer une structure cylindre creuse, ladite couche de corps rigide (G) ayant une épaisseur non inférieure à 0,01 mm et non supérieure à 0,5 mm.

7. Elément d'impression cylindrique creux selon l'une quelconque des revendications 1 à 6, dans lequel une résine photosensible durcie constituant au moins le matériau de noyau cylindrique creux (A) parmi le matériau de noyau cylindrique creux (A), la couche d'ajustement de circonférence (F), la couche d'amortissement (E), la couche de corps rigide (G), la couche de résine (B) et la couche de résine (C), est formée en faisant durcir par effet photochimique une composition de résine photosensible qui est dans un état liquide à 20 °C.

8. Elément d'impression cylindrique creux selon la revendication 2, dans lequel la couche de résine (B) réalisée par la couche de résine photosensible (3) durcie par gravure au laser comprend un composé ayant au moins une liaison choisie dans le groupe comprenant une liaison de carbonate, une liaison d'uréthane et une liaison d'ester, et un matériau poreux inorganique.

9. Elément d'impression cylindrique creux selon la revendication 1, dans lequel le matériau de noyau cylindrique creux (A) comprend des parties irrégulières sur une surface, les parties irrégulières ayant une différence en hauteur non inférieure à 20 µm et non supérieure à 500 µm.

10. Matériau de noyau cylindrique creux pour former un élément d'impression cylindrique creux, comprenant une couche de résine photosensible (1) durcie ayant une épaisseur non inférieure à 0,05 mm et non supérieure à 50 mm, ladite couche de résine photosensible (1) durcie comprenant un matériau de renforcement de type fibre, de type tissu ou de type film, et ladite couche de résine photosensible (1) durcie comprenant un photo-initiateur ou un produit de dégradation dudit photo-initiateur, dans lequel ledit photo-initiateur comprend un photo-initiateur à extraction d'hydrogène et un photo-initiateur dégradable, ou comprend un composé contenant, dans la même molécule, un groupe caractéristique qui sert de photo-initiateur à extraction d'hydrogène et un groupe caractéristique qui sert de photo-initiateur dégradable, et ladite couche de résine photosensible (1) durcie ayant une dureté Shore D non inférieure à 30 degrés et non supérieure à 100 degrés.

11. Procédé pour produire un matériau de base d'impression cylindrique creux comprenant les étapes consistant à :
appliquer une composition de résine photosensible qui comprend un photo-initiateur sur un support cylindrique ;
durcir par effet photochimique par rayonnement avec des faisceaux contenant de la lumière qui est comprise entre 200 nm et 450 nm ; ajuster l'épaisseur de film de la couche de résine photosensible durcie obtenue ; et empiler une couche de résine (B) modelable ou une couche de résine modelée en surface (C) sur un matériau de noyau cylindrique creux (A) formé à partir des étapes décrites ci-dessus, dans lequel ledit photo-initiateur comprend un photo-initiateur à extraction d'hydrogène et un photo-initiateur dégradable ou un composé ayant, dans la même molécule, un groupe caractéristique qui sert de photo-initiateur à extraction d'hydrogène et un groupe caractéristique qui sert de photo-initiateur dégradable.

12. Procédé selon la revendication 11, comprenant en outre l'étape consistant à : prévoir un matériau de renforcement de type fibre, de type tissu ou de type film sur une surface de support cylindrique avant l'étape consistant à appliquer ladite composition de résine photosensible.

13. Procédé selon la revendication 11, dans lequel l'étape consistant à appliquer une composition de résine photosensible est l'étape consistant à enrouler autour d'une surface de support cylindrique un matériau en forme de feuille obtenu en incorporant une composition de résine photosensible liquide ou un produit semi-durci d'une composition de résine photosensible liquide dans un matériau de type fibre, de type tissu ou de type film.

14. Procédé selon la revendication 12 ou 13, dans lequel un procédé pour empiler la couche de résine (B) comprend une étape consistant à appliquer une composition de résine photosensible ou une étape consistant à appliquer et ensuite à faire durcir par effet photochimique une composition de résine photosensible, ou une étape consistant à fixer une couche de composition de résine photosensible formée selon une forme de feuille à l'aide d'une colle ou d'une colle sensible à la pression ; et dans lequel un procédé pour empiler la couche de résine (C) comprend l'étape consistant à fixer un matériau en forme de feuille modelé à l'aide d'une colle ou d'une colle sensible à la pression.

15. Procédé selon la revendication 12 ou 13, comprenant en outre une étape consistant à former au moins une couche de résine (D) sur le support cylindrique avant l'étape consistant à former le matériau de noyau cylindrique creux (A), dans lequel ladite étape consistant à former la couche de résine (D) comprend une étape consistant à enrouler un film de résine autour du support cylindrique de sorte que les deux parties de bord dudit film de résine ne se chevauchent pas et de sorte qu'un joint, formé à l'endroit où les deux parties de bord se rencontrent, ne dépasse pas 2 mm, ou une étape consistant à recouvrir avec un tube de résine sans joint formé selon une forme cylindrique, ou bien une étape consistant à appliquer une composition de résine photosensible liquide sur un support cylindrique et à la faire durcir par effet photochimique en la rayonnant avec de la lumière.

16. Procédé selon l'une quelconque des revendications 12 à 15, comprenant une étape consistant à empiler une couche d'ajustement de circonférence (F) sur le matériau de noyau cylindrique creux (A) avant l'étape consistant à empiler la couche de résine (B) ou la couche de résine (C), dans lequel ladite étape consistant à empiler une couche d'ajustement de circonférence (F) comprend une étape consistant à appliquer une résine photosensible liquide sur le matériau de noyau cylindrique creux (A) et à la faire durcir par effet photochimique en la rayonnant avec de la lumière.

17. Procédé selon la revendication 16, comprenant une étape consistant à empiler une couche d'amortissement (E) sur le matériau de noyau cylindrique creux (A) ou une couche d'ajustement de circonférence (F) avant l'étape consistant à empiler la couche de résine (B) ou bien la couche de résine (C), dans lequel ladite étape consistant à empiler une couche d'amortissement (E) comprend une étape consistant à appliquer une résine photosensible liquide sur le matériau de noyau cylindrique creux (A) ou la couche d'ajustement de circonférence (F) et à la faire durcir par effet photochimique en la rayonnant avec de la lumière, ou une étape consistant à fixer une bande d'amortissement à l'aide d'une couche adhésive ou d'une couche adhésive sensible à la pression.

18. Procédé selon la revendication 17, comprenant une étape consistant à empiler une couche de corps rigide (G) sur la couche d'amortissement (E) avant l'étape consistant à empiler la couche de résine (B) ou la couche de résine (C), dans lequel ladite étape consistant à empiler une couche de corps rigide (G) comprend une étape consistant à fixer un film de résine sur la couche d'amortissement (E) à l'aide d'une couche adhésive ou d'une couche adhésive sensible à la pression, ou bien une étape consistant à appliquer une composition de résine photosensible liquide et la faire durcir par effet photochimique en la rayonnant avec de la lumière.

19. Procédé selon l'une quelconque des revendications 12 à 18, comprenant en outre, après une étape consistant à ajuster (ou à former) une épaisseur de film de la couche de résine photosensible (1) durcie, au moins une étape choisie dans le groupe comprenant une étape consistant à découper une surface, une étape consistant à meuler une surface et une étape consistant à polir une surface.

20. Procédé selon l'une quelconque des revendications 12 à 19, dans lequel, à l'étape consistant à former la couche de résine photosensible (1) durcie, la couche de composition de résine photosensible est rayonnée avec de la lumière dans l'air.

21. Procédé selon l'une quelconque des revendications 12 à 20, comprenant, après la formation de l'élément d'impression cylindrique creux, une étape consistant à retirer ledit élément d'impression cylindrique creux du support cylindrique.
